# EUROPEAN PATENT APPLICATION

(11) **EP 1 605 507 A2**
(43) Date of publication of application: **14.12.2005**
(21) Application number: 05012238.1
(22) Date of filing: 07.06.2005
(51) Int. Cl.: H01L 27/00

(54) **Display device and method of manufacturing the same**

(30) Priority: 07.06.2004 JP 2004168619; 09.06.2004 JP 2004171192
(71) Applicant: CASIO COMPUTER CO., LTD., Shibuya-ku, Tokyo 151-8543 (JP)
(72) Inventor: Shirasaki, Tomoyuki c/o Casio Computer Co., Ltd., Hamura-shi Tokyo 105-8555 (JP); Tohyama, Tadahisa c/o Casio Computer Co., Ltd., Hamura-shi Tokyo 105-8555 (JP); Takei, Manabu c/o Casio Computer Co., Ltd., Hamura-shi Tokyo 105-8555 (JP); Ogura, Jun c/o Casio Computer Co., Ltd., Hamura-shi Tokyo 105-8555 (JP); Yamaguchi, Ikuhiro c/o Casio Computer Co., Ltd., Hamura-shi Tokyo 105-8555 (JP); Ozaki, Tsuyoshi c/o Casio Computer Co., Ltd., Hamura-shi Tokyo 105-8555 (JP)
(74) Representative: Grünecker, Kinkeldey, Stockmair & Schwanhäusser Anwaltssozietät

(57) **Abstract**

A display device includes a substrate (2), and a light-emitting element which is provided on one side of the substrate. A pixel circuit (6) is provided on the side of the substrate, and has at least one electrode (7S-9S, 7D-9D) to drive the light-emitting element. An interconnection (18, 19) is provided on the side of substrate (2), is electrically connected to the pixel circuit and has a conductive layer different from the electrode of the pixel circuit (6).

## Description

The present invention relates to a display device having light-emitting elements and a method of manufacturing the same.

Display devices can roughly be classified into non-selfluminous display devices such as a liquid crystal display device and selfluminous display devices such as a plasma display and an organic electroluminescent display device. These display devices can be also classified into passive driving devices and active matrix driving devices. The active matrix driving organic electroluminescent display devices are more excellent than the passive driving devices because of their high contrast and high resolution. For example, in an active matrix driving organic electroluminescent display device described in Jpn. Pat. Appln. KOKAI Publication No. 8-330600, an organic electroluminescent element (to be referred to as an organic El element hereinafter), a driving transistor which supplies a current to the organic El element when a voltage signal corresponding to image data is applied to the gate, and a switching transistor which executes switching to supply the voltage signal corresponding to the image data to the gate of the driving transistor are provided for each pixel. In the organic electroluminescent display panel, when a scanning line is selected, the switching transistor is turned on. At this time, a signal voltage of a potential as the luminance data of the organic El element is applied to the gate of the driving transistor through a data line. Hence, the driving transistor is turned on. A driving current having a magnitude corresponding to the gate voltage value flows from the power supply to the organic El element through the source and drain of the driving transistor so that the organic El element emits light at a luminance corresponding to the magnitude of the current. During the time after selection of the scanning line is ended until the next scanning line is selected, the gate voltage value of the driving transistor is continuously held even when the switching transistor is turned off. Hence, the organic El element emits light at a luminance corresponding to the magnitude of the driving current corresponding to the voltage.

In the organic electroluminescent display device, driving circuits are provided in the periphery of the organic electroluminescent display panel to apply voltages to the scanning lines, data lines, and power supply line formed on the organic electroluminescent display panel.

In the conventional active matrix driving organic electroluminescent display device, the scanning lines, data lines, and power supply line are patterned simultaneously in the process of patterning pixel circuits such as switching transistors and driving transistors. More specifically, in manufacturing the organic electroluminescent display device, photolithography and etching are executed for a thin film as the prospective electrodes of the pixel circuits. With this process, the electrodes of the pixel circuits are shaped from the thin film. Simultaneously, interconnections to be connected to the electrodes are also shaped.

When the interconnections are formed from the thin film as the prospective electrodes of the pixel circuits, the interconnections have the same thickness as the electrodes of the pixel circuits. However, the thickness of the electrodes of the pixel circuits is designed in accordance with the required characteristics of the pixel circuits. Hence, when the current is supplied to the plurality of pixel circuits, the resistance of the interconnections is high. For this reason, a voltage drop readily occurs depending on the electrical resistance or parasitic capacitance of the interconnections. Alternatively, the current readily delays through the interconnections. Especially an interconnection connected to a plurality of pixel circuits must have a low resistance because a relatively large current needs to be supplied for the plurality of light-emitting elements.

The present invention has been made to solve the above-described problems, and has as its object to suppress any voltage drop or current delay.

In order to solve the above problems, according to a first aspect, a display device comprising:
a substrate;
a light-emitting element which is provided on one side of the substrate;
a pixel circuit which is provided on the side of the substrate, and has at least one electrode to drive the light-emitting element; and
an interconnection which is provided on the side of substrate, is electrically connected to the pixel circuit and has a conductive layer different from the electrode of the pixel circuit.

According to a second aspect of the present invention, there is provided a display device comprising:
a substrate;
a plurality of light-emitting elements;
a plurality of pixel circuits each of which has at least one electrode to drive a corresponding one of the light-emitting elements; and
a pixel circuit connecting interconnection which is electrically connected to the plurality of pixel circuits and has a conductive layer different from the electrode of the pixel circuit,
the light emitting elements, pixel circuits and pixel circuit interconnection being on one side of the substrate.

According to a third aspect of the present invention, there is provided a display device comprising:
a substrate;
a plurality of light-emitting elements which are provided on or above the substrate;
a plurality of pixel circuits each of which has an electrode to drive a corresponding one of the light-emitting elements; and
a light-emitting element connecting interconnection which is connected to the plurality of light-emitting elements and has a conductive layer different from the electrode of the pixel circuit.

According to a fourth aspect of the present invention, there is provided a display device comprising:
a plurality of light-emitting elements each of which has a light-emitting layer;
a plurality of pixel circuits which drive the plurality of light-emitting elements, respectively; and
an interconnection which is connected to one of the pixel circuit and the light-emitting element and has a conductive layer which partitions the light-emitting layer as at least one side of a block where the light-emitting layer of the light-emitting element is formed.

A display device manufacturing method according to a fifth aspect of the present invention is a method of manufacturing a display device, comprising:
forming a pixel circuit connecting interconnection which is connected to a plurality of pixel circuits provided on a substrate and has a conductive layer different from an electrode of the pixel circuit.

In the present invention, since the pixel circuit connecting interconnection or light-emitting element connecting interconnection having a conductive layer different from the electrode of the pixel circuit is provided, the electrical resistance of the pixel circuit connecting interconnection or light-emitting element connecting interconnection can be made lower than that of the pixel circuit. For this reason, any current delay or voltage drop in the interconnection can be suppressed.

According to a sixth aspect of the present invention, there is provided a method of manufacturing a display device, comprising:
providing an interconnection which has a conductive layer different from electrodes of a plurality of pixel circuits provided on a substrate; and
forming a light-emitting layer by using the interconnection as a partition.

In the present invention, since the interconnection having a conductive layer different from the electrode of the pixel circuit is provided, the electrical resistance of the interconnection can be made lower than that of the electrode of the pixel circuit. For this reason, any current delay or voltage drop in the interconnection can be suppressed.

This summary of the invention does not necessarily describe all necessary features so that the invention may also be a sub-combination of these described features.

The invention can be more fully understood from the following detailed description when taken in conjunction with the accompanying drawings, in which:
FIG. 1 is an equivalent circuit diagram of a transistor array substrate 1;
FIG. 2 is a sectional view for explaining a step in manufacturing an electroluminescent display panel according to the first embodiment;
FIG. 3 is a sectional view for explaining a step following FIG. 2;
FIG. 4 is a sectional view for explaining a step following FIG. 3;
FIG. 5 is a sectional view for explaining a step following FIG. 4;
FIG. 6 is a sectional view for explaining a step following FIG. 5;
FIG. 7 is a sectional view for explaining a step following FIG. 6;
FIG. 8 is a plan view in the state shown in FIG. 5;
FIG. 9 is a plan view of a display device;
FIG. 10 is an equivalent circuit diagram of the display device;
FIG. 11 is a sectional view for explaining a step in manufacturing an electroluminescent display panel according to the second embodiment;
FIG. 12 is a sectional view for explaining a step following FIG. 11;
FIG. 13 is a sectional view for explaining a step following FIG. 12;
FIG. 14 is a sectional view for explaining a step following FIG. 13;
FIG. 15 is a sectional view for explaining a step following FIG. 14;
FIG. 16 is a sectional view for explaining a step following FIG. 15;
FIG. 17 is a sectional view for explaining a step in manufacturing an electroluminescent display panel according to the third embodiment;
FIG. 18 is a sectional view for explaining a step following FIG. 17;
FIG. 19 is a sectional view for explaining a step following FIG. 18;
FIG. 20 is a sectional view for explaining a step following FIG. 19;
FIG. 21 is a sectional view for explaining a step following FIG. 20;
FIG. 22 is a sectional view for explaining a step following FIG. 21;
FIG. 23 is a sectional view for explaining a step in manufacturing an electroluminescent display panel according to the fourth embodiment;
FIG. 24 is a sectional view for explaining a step following FIG. 23;
FIG. 25 is a sectional view for explaining a step following FIG. 24;
FIG. 26 is a sectional view for explaining a step following FIG. 25;
FIG. 27 is a sectional view for explaining a step following FIG. 26;
FIG. 28 is a sectional view for explaining a step following FIG. 27;
FIG. 29 is a sectional view for explaining a step in manufacturing an electroluminescent display panel according to the fifth embodiment;
FIG. 30 is a sectional view for explaining a step following FIG. 29;
FIG. 31 is a sectional view for explaining a step following FIG. 30;
FIG. 32 is a sectional view for explaining a step following FIG. 31;
FIG. 33 is a sectional view for explaining a step following FIG. 32;
FIG. 34 is a sectional view for explaining a step following FIG. 33;
FIG. 35 is a sectional view for explaining a step in manufacturing an electroluminescent display panel according to the sixth embodiment;
FIG. 36 is a sectional view for explaining a step following FIG. 35;
FIG. 37 is a sectional view for explaining a step following FIG. 36;
FIG. 38 is a sectional view for explaining a step following FIG. 37;
FIG. 39 is a sectional view for explaining a step following FIG. 38;
FIG. 40 is a sectional view for explaining a step following FIG. 39;
FIG. 41 is a plan view in the state shown in FIG. 38;
FIG. 42 is a sectional view for explaining a step in manufacturing an electroluminescent display panel according to the seventh embodiment;
FIG. 43 is a sectional view for explaining a step following FIG. 42;
FIG. 44 is a sectional view for explaining a step in manufacturing an electroluminescent display panel according to the eighth embodiment;
FIG. 45 is a sectional view for explaining a step following FIG. 44;
FIG. 46 is a sectional view for explaining a step following FIG. 45;
FIG. 47 is a sectional view for explaining a step following FIG. 46;
FIG. 48 is a sectional view for explaining a step following FIG. 47;
FIG. 49 is a sectional view for explaining a step following FIG. 48;
FIG. 50 is a sectional view for explaining a step following FIG. 49;
FIG. 51 is a sectional view for explaining a step in manufacturing an electroluminescent display panel according to the ninth embodiment;
FIG. 52 is a sectional view for explaining a step following FIG. 51;
FIG. 53 is a sectional view for explaining a step following FIG. 52;
FIG. 54 is a sectional view for explaining a step following FIG. 53;
FIG. 55 is a sectional view for explaining a step following FIG. 54;
FIG. 56 is a sectional view for explaining a step following FIG. 55;
FIG. 57 is a sectional view for explaining a step in manufacturing an electroluminescent display panel according to the 10th embodiment;
FIG. 58 is a sectional view for explaining a step following FIG. 57;
FIG. 59 is a sectional view for explaining a step following FIG. 58;
FIG. 60 is a sectional view for explaining a step following FIG. 59; and
FIG. 61 is a sectional view for explaining a step following FIG. 60.

Preferred embodiments of the present invention will be described below with reference to the accompanying drawings. The embodiments to be described below include various kinds of limitations which are preferable in terms of techniques for practicing the present invention. However, the scope of the present invention is not limited to the following embodiments and illustrated examples.

### [First Embodiment]

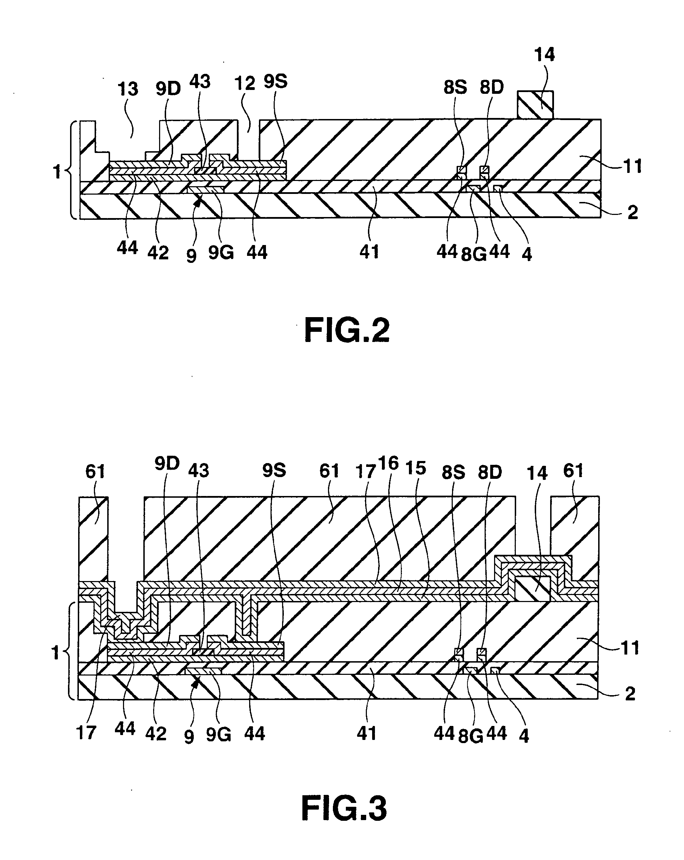

A method of manufacturing a display device having, as pixels, organic electroluminescent elements serving as light-emitting elements will be described with reference to FIGS. 2 to 7. FIGS. 2 to 7 are sectional views of steps in the manufacturing method. The steps are executed in the order of FIGS. 2 to 7.

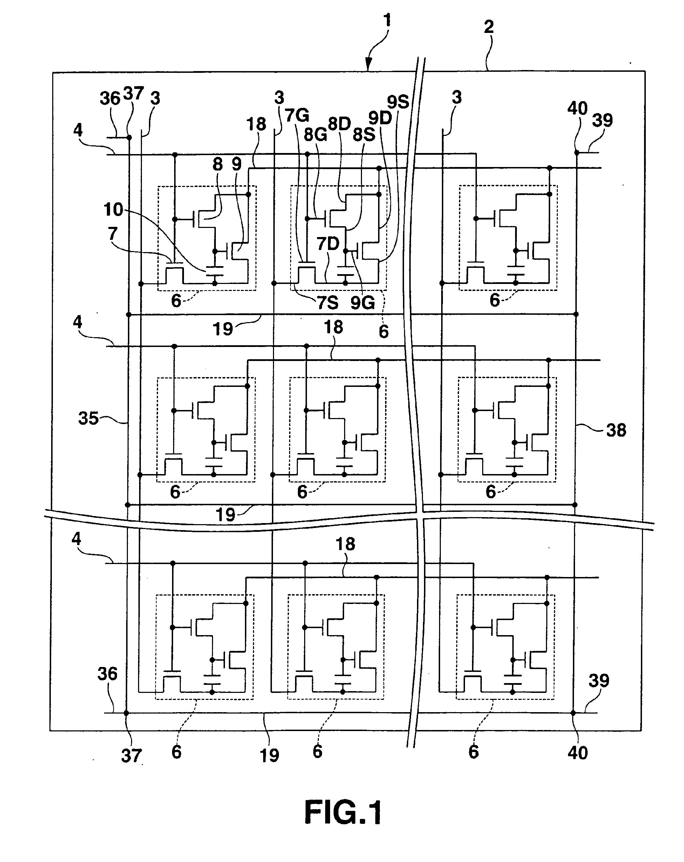

A transistor array substrate 1 having pixel circuits, as shown in FIGS. 1 and 2 is manufactured. The transistor array substrate 1 is a current luminance gray level control panel. A pixel circuit 6 does not execute voltage luminance gray level control by a signal voltage, unlike the prior art. Instead, a luminance gray level current (storage current) having a current value corresponding to luminance gray level data is supplied into the pixel circuit 6 to generate a driving current having a current value corresponding to the current value of the luminance gray level current. The driving current is supplied to an organic EL element 26 (to be described later) to control the gray level. The transistor array substrate 1 is manufactured by patterning, on a substrate 2, a plurality of transistors 7, 8, 9 and a capacitor 10 serving as part of the pixel circuit 6 by appropriately executing a film forming process such as vapor deposition (e.g., PVD, CVD, and sputtering), a mask process such as photolithography and metal mask, and a shaping process such as etching.

More specifically, as shown in FIG. 1, the transistor array substrate 1 comprises the insulating transparent substrate 2, a plurality of signal current lines (data lines) 3, a plurality of scanning lines 4, a plurality of current source lines 18 and EL lines 19 and the plurality of pixel circuits 6. The substrate 2 is obtained by forming glass or a resin into a sheet or plate shape. The signal current lines 3 are arrayed on the substrate 2 to be parallel to each other. The scanning lines 4 are arrayed on the substrate 2 to be parallel to each other and perpendicular to the signal current lines 3 when the substrate 2 is viewed from the upper side. The current source line 18 and EL lines 19 are arrayed between the adjacent scanning lines 4 on the substrate 2 to be parallel to the scanning lines 4. The pixel circuits 6 are arrayed on the substrate 2 to form a two-dimensional or matrix array along the signal current lines 3 and scanning lines 4.

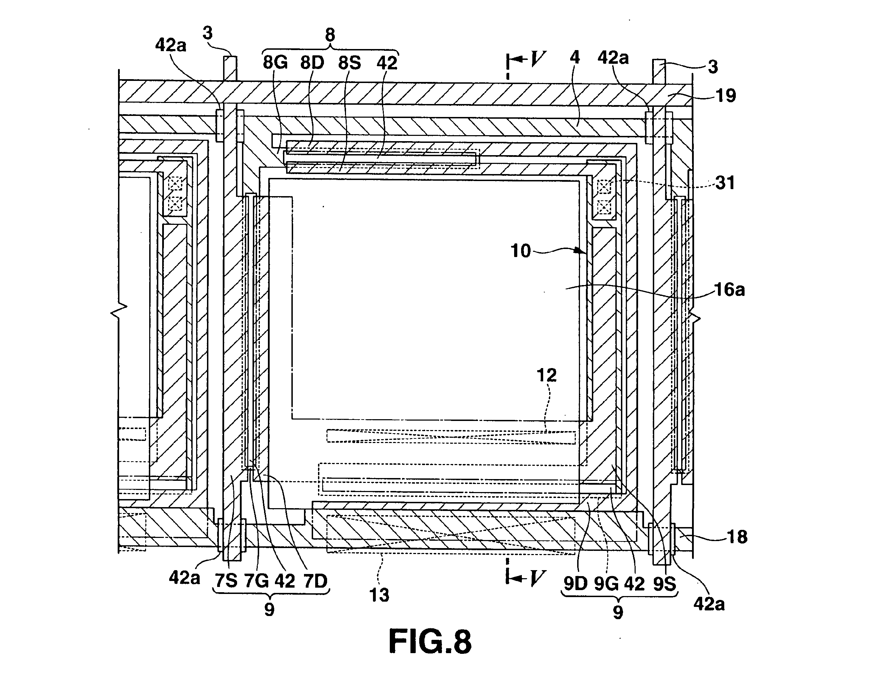

Each pixel circuit 6 is provided in the periphery of a pixel. The pixel circuit 6 has the three thin-film transistors (to simply be referred to as transistors hereinafter) 7, 8, and 9 and the capacitor 10. Each of the transistors 7, 8, and 9 is an n-channel MOSFET transistor which has a gate insulating films 41 (FIG. 2), semiconductor layer 42 (FIG. 2), blocking insulating film 43 (FIG. 2), two impurity-doped semiconductor layers 44 (FIG. 2), and drain 8D (9D) (drain 7D is not illustrated in FIG. 2), and source 8S (9S) (source 7S is not illustrated in FIG. 2). The gate insulating film 41 covers gates 7G, 8G, and 9G (gate 7G is not illustrated in FIG. 2). The semiconductor layers 42 oppose the gates 7G, 8G, and 9G through the gate insulating film 41. The blocking insulating film 43 protect the channel surfaces of semiconductor layers 42 from an etchant. The impurity semiconductor layers 44 are formed on the two ends of each semiconductor layer 42. Each of the drains 8D and 9D is formed on one of the corresponding impurity-doped semiconductor layers 44. Each of the sources 8S and 9S is formed on the other of the corresponding impurity-doped semiconductor layers 44. Especially, each of the transistors 7, 8, and 9 is an a-Si transistor using amorphous silicon for the semiconductor layer 42 (channel region). They may be p-Si transistors using polysilicon for the semiconductor layer 42. The transistors 7, 8, and 9 can have an inverted stagger structure, coplanar structure, or any other structure. The first transistor 7 will be referred to as a current path control transistor, the second transistor 8 as a holding transistor, and the third transistor 9 as a current control transistor hereinafter. A circuit comprising the current path control transistor 7 and holding transistor 8 corresponds to a switch circuit which supplies a storage current having a predetermined current value to the signal current line 3 during the selection period and stops supplying the current to the signal current line 3 during the non-selection period. A circuit comprising the current control transistor 9 and capacitor 10 corresponds to a current storage circuit which stores current data corresponding to the current value of the storage current flowing through the signal current line 3 during the selection period and supplies, to the organic EL element 26 (FIG. 8), a driving current having a current value corresponding to the current value of the storage current during the non-selection period in accordance with the current data stored during the selection period. The current path control transistor 7 has a function of controlling the current path to supply the driving current from the current control transistor 9 not to the signal current line 3 but to the organic EL element 26 during the non-selection period. The holding transistor 8 has a function of holding the voltage between the gate 9G and source 9S of the current control transistor 9 corresponding to the current value of the storage current flowing during the selection period until the non-selection period. FIGS. 2 to 7 are sectional views of one pixel in the transistor array substrate 1 obtained by cutting the current control transistor 9 along a plane perpendicular to the scanning line 4. The remaining pixels also take the states shown in FIGS. 2 to 7 in the respective steps.

As shown in FIG. 1, the gate 7G of the current path control transistor 7 is connected to the scanning line 4. The source 7S of the transistor 7 is connected to the signal current line 3. The drain 7D of the transistor 7 is connected to the source 9S of the current control transistor 9. The gate 8G of the holding transistor 8 is connected to the scanning line 4. The drain 8D of the transistor 8 is connected to the drain 9D of the current control transistor 9 and the current source line 18. The source 8S of the holding transistor 8 is connected to the gate 9G of the current control transistor 9. The drain 9D of the transistor 9 is connected to the current source line 18. The capacitor 10 has a first electrode connected to the gate 9G of the current control transistor 9, a second electrode connected to the source 9S of the current control transistor 9, and a dielectric film inserted between the two electrodes. The capacitor 10 has a function of accumulating charges between the gate 9G and source 9S of the current control transistor 9. The dielectric film of the capacitor 10 may have a part of the gate insulating film 41.

The first, second, and third transistors 7, 8, and 9 are patterned simultaneously in the same process. For this reason, the compositions of the gates 7G, 8G, and 9G, gate insulating films 41, semiconductor layers 42, impurity-doped semiconductor layers 44, drains 7D, 8D, and 9D, sources 7S, 8S, and 9S are the same between the transistors 7, 8, and 9. However, the transistors 7, 8, and 9 have different shapes, sizes, dimensions, channel widths, and channel lengths in accordance with the their functions.

The signal current lines 3 are formed by patterning a source/drain conductive film as the prospective sources 7S, 8S, and 9S and drains 7D, 8D, and 9D of the transistors 7, 8, and 9 simultaneously in the same process.

The scanning lines 4 are formed by patterning a gate conductive film as the prospective gates 7G, 8G, and 9G of the transistors 7, 8, and 9 simultaneously in the same process.

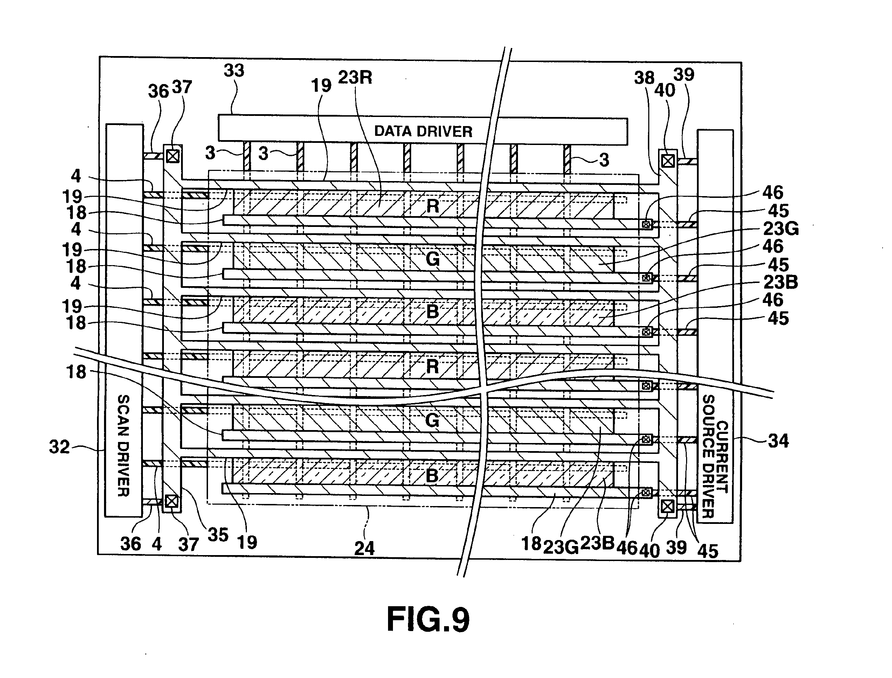

Interconnections 36, interconnections 39, and a plurality of interconnections 45 shown in FIG. 9 are obtained by forming the upper layer by patterning the gate conductive film and the lower layer by patterning the source/drain conductive film. The pair of interconnections 36, the pair of interconnections 39, and the plurality of interconnections 45 are provided in the non-display region. Hence, even when they are thin like the gate conductive film or source/drain conductive film, the resistance can sufficiently be reduced by forming them wide.

Referring back to FIG. 2, a planarizing film 11 is provided to the entire surface of the transistor array substrate 1. The planarizing film 11 covers the signal current lines 3, scanning lines 4, and pixel circuits 6. The planarizing film 11 is formed by forming, on an inorganic interlayer dielectric film of silicon nitride or silicon oxide to protect the transistors 7, 8, and 9, a photosensitive insulating film of polyimide so thick to planarize the surface of the interlayer dielectric film. In this specification, of the layers of the transistor array substrate 1, the multilayered film from the surface of the substrate 2 to the surface of the planarizing film 11 will be referred to as a transistor layer.

As shown in FIG. 2, photolithography and etching are executed for the prepared transistor array substrate 1 to form, in the planarizing film 11, a contact hole 12 communicating with the source 9S of each current control transistor 9 and a contact hole 13 exposing the drain 9D of each current control transistor 9. Simultaneously, as shown in FIG. 9, a contact hole 37 is formed in the planarizing film 11 on one end of each interconnection 36. A contact hole 40 is formed in the planarizing film 11 on one end of each interconnection 39. A contact hole 46 is formed at one end of each current source line 18.

As shown in FIG. 2, an organic EL isolation insulating film 14 made of silicon nitride or silicon oxide is formed by patterning to be parallel to the scanning lines 4 between pixels adjacent in the longitudinal direction (column direction). The organic EL isolation insulating film 14 is patterned by a thin film forming process such as vapor deposition, a mask process such as photolithography, and a shaping process such as etching.

As shown in FIG. 3, a reflecting metal film 15 which has a high reflectance and is made of a metal material such as gold, silver, copper, aluminum, titanium, or chromium is formed on the entire surface of the transistor array substrate 1 by vapor deposition such as sputtering. The reflecting metal film 15 is formed on the surface even in the contact holes 12 and 13.

A transparent metal oxide film 16 is formed on the entire surface of the reflecting metal film 15 by vapor deposition such as sputtering. The transparent metal oxide film 16 is made of indium oxide, zinc oxide, tin oxide, or a mixture containing at least one of them (e.g., indium tin oxide (ITO), indium zinc oxide, or cadmium-tin oxide (CTO)). The transparent metal oxide film 16 is formed on the surface even in the contact holes 12 and 13.

A metal layer 17 is formed on the entire surface of the transparent metal oxide film 16. The metal layer 17 has a lower layer with a thickness of about 30 to 50 nm and an upper layer with a thickness of about 500 nm. The lower layer is formed from a metal material such as copper or nickel by vapor deposition such as sputtering. The upper layer is formed from copper by electroplating.

A photoresist film 61 is formed while exposing the metal layer 17 at a portion which overlaps the contact hole 13 along the row direction and the metal layer 17 at a portion which overlaps the organic EL isolation insulating film 14 along the row direction. In addition, the photoresist film 61 also exposes the metal layer 17 connected to the interconnections 36 through the contact holes 37, the metal layer 17 connected to the interconnections 39 through the contact holes 40, and the metal layer 17 connected to the interconnections 45 through the contact holes 46.

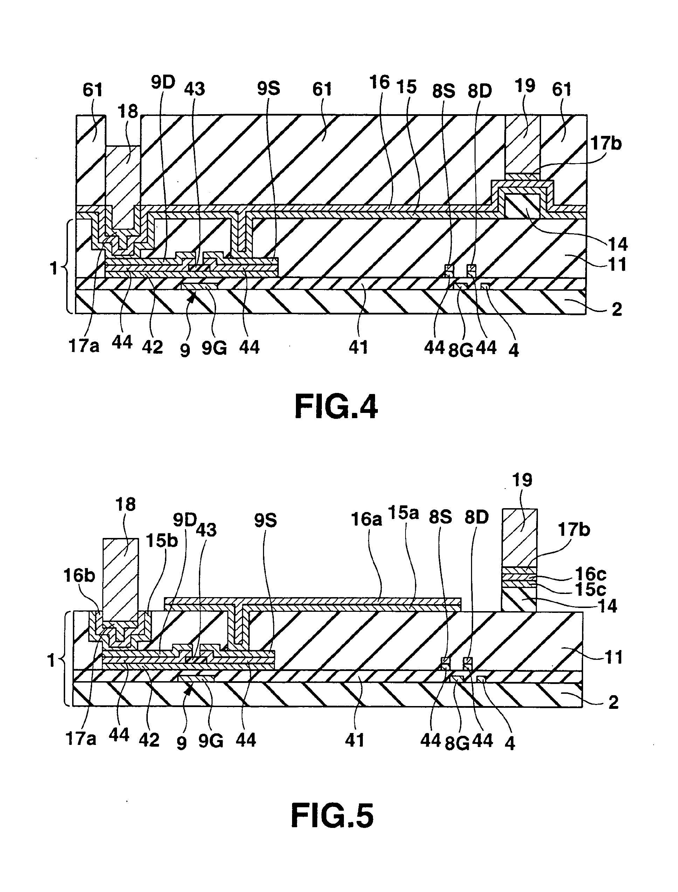

When electroplating is executed by using the exposed metal layers 17 as electrodes, the current source line 18 and EL line 19 made of a copper plating film having a thickness of 2 to 100 µm and a width of 2 to 50 µm are formed on the exposed metal layers 17, as shown in FIG. 4. In addition, a common interconnection 35 which connects the EL lines 19 to each other on the left side of the display region and a common interconnection 38 which connects the EL lines 19 to each other on the right side of the display region are formed. The common interconnection 35 is connected to the interconnections 36 through the contact holes 37. The common interconnection 38 is connected to the interconnections 39 through the contact holes 40. The current source lines 18 are connected to the interconnections 45 through the contact holes 46.

The current source lines 18, EL lines 19, and common interconnections 35 and 38 are deposited thicker than the sources 7S, 8S, and 9S and drains 7D, 8D, and 9D of the transistors 7, 8, and 9. The resistance per unit length of the current source lines 18, EL lines 19, and common interconnections 35 and 38 is lower than the resistance per unit length of the sources 7S, 8S, and 9S and drains 7D, 8D, and 9D of the transistors 7, 8, and 9. The resistivity of the current source lines 18, EL lines 19, and common interconnections 35 and 38 is preferably lower than the resistivity of the conductive material of the sources 7S, 8S, and 9S and drains 7D, 8D, and 9D of the transistors 7, 8, and 9. The current source lines 18, EL lines 19, and common interconnections 35 and 38 are deposited thicker than the gates 7G, 8G, and 9G of the transistors 7, 8, and 9. The resistance per unit length of the current source lines 18, EL lines 19, and common interconnections 35 and 38 is lower than the resistance per unit length of the gates 7G, 8G, and 9G of the transistors 7, 8, and 9. The resistivity of the current source lines 18, EL lines 19, and common interconnections 35 and 38 is preferably lower than the resistivity of the conductive material of the gates 7G, 8G, and 9G of the transistors 7, 8, and 9. The current source lines 18 correspond to the conductive layer of the pixel circuit connecting interconnection. The pixel circuits 6 arrayed in the same row along the scanning line 4 are connected to the same current source line 18. The current source lines 18, EL lines 19, and common interconnections 35 and 38 are resistances and are formed long. To the contrary, the interconnections 36, 39, and 45 are relatively short and less affect the entire interconnection resistance.

The number of current source line 18, the number of EL line 19, and the number of interconnections 45 equal the number of scanning lines 4. Each row has one current source line 18, one EL line 19, one interconnection 45, and one scanning line 4. After that, the photoresist film 61 is removed. The copper thick film may be formed by sputtering, sublimation deposition, or dispenser method in place of electroplating.

The metal layer 17 except the portions covered with the current source lines 18, EL lines 19, and common interconnections 35 and 38 is shaped by etching to form an underlayer 17a under the current source line 18 and an underlayer 17b under the EL line 19.

As shown in FIG. 5, by using, as a mask, a resist mask formed by executing photolithography and etching for the transparent metal oxide film 16, the transparent metal oxide film 16 is left for each pixel to pattern a pixel electrode 16a. In addition, the transparent metal oxide film 16 provided under the underlayer 17a is left by using the current source line 18 as a mask to form a transparent metal oxide underlying film 16b. The transparent metal oxide film 16 provided under the underlayer 17b is left to form a transparent metal oxide underlying film 16c. The transparent metal oxide film 16 is patterned such that the remaining pixel electrode 16a overlaps the contact hole 12 and is independent for each pixel when viewed from the upper side. The pixel electrode 16a functions as the anode of the organic EL element 26 (to be described later) (FIG. 8). The underlayer 17a and transparent metal oxide underlying film 16b have almost the same shape as the current source line 18 and run in the row direction. The underlayer 17b and transparent metal oxide underlying film 16c have almost the same shape as the EL line 19 and run in the row direction. FIG. 5 is a sectional view of a plane taken along a line V - V in FIG. 8 (to be described later) and viewed from the direction of arrows.

The reflecting metal film 15 is patterned into the same shape as the pixel electrode 16a by using the pixel electrode 16a and resist mask as a mask to form a reflecting metal underlying film 15a. The reflecting metal film 15 under the transparent metal oxide underlying film 16b is left by etching to form a reflecting metal underlying film 15b. The reflecting metal film 15 under the transparent metal oxide underlying film 16c is left by etching to form a reflecting metal underlying film 15c. The reflecting metal underlying film 15a overlaps the contact hole 12 when viewed from the upper side. For this reason, the pixel electrodes 16a are electrically insulated from each other for each pixel. The pixel electrode 16a is connected to the source 9S of the current control transistor 9 of the pixel. FIG. 1 is a circuit diagram showing the transistor array substrate 1 in the state in FIG. 5.

In the transistor array substrate 1 without the organic EL elements 26, a test scan driver is connected to the scanning lines 4. A test driving driver to output a predetermined voltage is connected to the current source lines 18. A test current control driver to supply a current having a predetermined current value to the signal current lines 3 is connected to the signal current lines 3. A predetermined voltage is applied from the driving driver to the scanning lines 4 and current source lines 18. A predetermined current is supplied from the current control driver to the signal current lines 3. In this way, it can be tested whether the current having the predetermined current value flows from the current source lines 18 to the signal current lines 3 through the path between the source 9S and drain 9D of the current control transistor 9 and the path between the source 7S and drain 7D of the current path control transistor 7 of each pixel circuit 6. It can be confirmed whether each pixel circuit 6 is normal before the organic EL elements 26 are provided. If one of the transistors 7, 8, and 9 and capacitor 10 of a certain pixel circuit 6 of the transistor array substrate 1 has an operation error and is recognized as a defective, the organic EL elements 26 need not be formed on the transistor array substrate 1. Hence, the productivity can be increased.

FIG. 8 is a plan view of the main elements of the pixel circuit 6 in the state shown in FIG. 5. The current source line 18 and EL line 19 are provided in parallel to the scanning line 4. As shown in FIG. 5, the current source line 18 is formed to partially match the underlayers 17a provided in the contact holes 13 of all pixels arrayed in the lateral direction (row direction), i.e., the pixels of each row when viewed from the upper side. Hence, the drains 9D of the current control transistors 9 of all pixels of each row are electrically connected to the current source line 18 of the row.

Referring to FIG. 8, in addition to the gate insulating film 41, a protective film 42a obtained by patterning the same film as the semiconductor layer 42 is formed between the signal current line 3 formed integrally with the sources 7S, 8S, and 9S of the transistors 7, 8, and 9 and the scanning line 4 formed integrally with the gates 7G, 8G, and 9G of the transistors 7, 8, and 9. The source 8S of the holding transistor 8 and the gate 9G of the current control transistor 9 are connected to each other through a contact hole 31 provided in the gate insulating film 41.

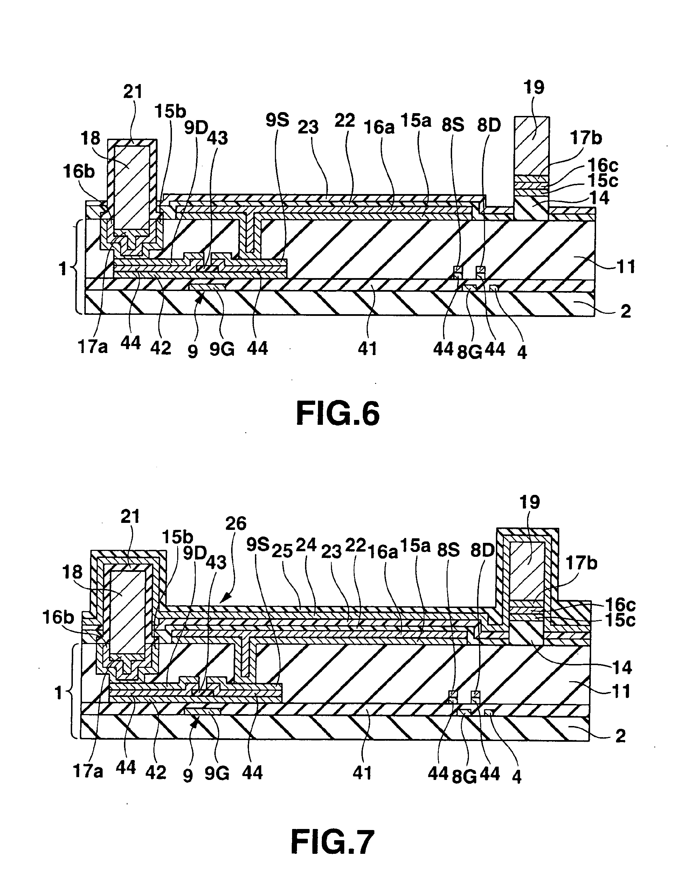

As shown in FIG. 6, a current source line insulating film 21 is formed by electrodeposition coating by applying a voltage to each current source line 18 so that only the surfaces of the current source lines 18 and common interconnections 35 and 38 are selectively covered. Instead of forming the current source line insulating film 21, the surfaces of the current source lines 18 and common interconnections 35 and 38 may be anodized to cover them by an insulating film.

Alternatively, the current source line insulating film 21 formed from an inorganic insulating film of silicon nitride or silicon oxide or a water-repellent organic insulating film may be patterned by vapor deposition, photolithography, and etching to cover only the current source lines 18. Alternatively, the current source line insulating film 21 made of an insulating material may be patterned by executing spin coating by using a mask and peeling the mask (lift-off method) to cover only the current source lines 18.

As shown in FIG. 6, a hole transport layer 22 is formed by wet film formation such as droplet discharge (ink jet), spin coating, dip coating, or dropping by a needle by using a solution containing polythiophene (PEDOT) and polystyrene sulfonate (PSS) as a dopant. The hole transport layer 22 may be formed on the entire surface of the transistor array substrate 1 and shared by all pixels. Alternatively, the hole transport layer 22 may be formed independently for each pixel. The current source line insulating film 21 and organic EL isolation insulating film 14 preferably exhibit liquid repellency against the hole transport layer material containing solution or light-emitting layer material containing solution. When they have liquid repellency, the films of the hole transport layer material containing solution and light-emitting layer material containing solution are not formed locally along the current source line 18 and EL line 19. Hence, the films can be formed with uniform thicknesses on the pixel electrode 16a. FIG. 6 shows a state in which after the region surrounded by the current source line 18 and EL line 19 is filled with a solution or suspension containing the material of the hole transport layer 22, the solvent or water volatilizes to form the hole transport layer 22.

After the hole transport layer 22 is dried, a light-emitting layer 23 is formed by wet film formation such as droplet discharge (ink jet), spin coating, dip coating, or injection by a needle by using a solution containing a polyparavinylene-based light-emitting or polyfluorene-based light-emitting material having conjugated double bonds. As shown in FIG. 9, the light-emitting layer 23 is formed continuously for a plurality of pixels along the current source line 18 and EL line 19. Red light-emitting layers 23R to emit red light, green light-emitting layers 23G to emit green light, and blue light-emitting layers 23B to emit blue light are formed for the respective rows. The reflecting metal underlying film 15c, transparent metal oxide underlying film 16c, underlayer 17b, and EL line 19 remain on the organic EL isolation insulating film 14. The hole transport layer 22 and light-emitting layer 23 are thinner than the organic EL isolation insulating film 14. The height of the solution or suspension as the prospective hole transport layer 22 and the height of the solution or suspension as the prospective light-emitting layer 23 which covers the pixel region are smaller than the height of the current source line 18 and the height of the EL line 19. Hence, the solution or suspension as the prospective hole transport layer 22 and the solution or suspension as the prospective light-emitting layer 23 do not flow to a pixel of an adjacent row over the current source line 18 and EL line 19. That is, the current source line 18 and EL line 19 function as partitions to prevent any outflow of the solution or suspension as the prospective hole transport layer 22 and the solution or suspension as the prospective light-emitting layer 23. Hence, as shown in FIG. 9, when a plurality of pixels in the row direction surrounded along the current source line 18 and EL line 19 should have light-emitting layers which emit the same color light, the light-emitting layers 23 for the plurality of pixels in the row direction can be formed at once by supplying the solution or suspension for the light-emitting layer 23 between the current source line 18 and the EL line 19.

As shown in FIG. 7, a common electrode 24 serving as a cathode electrode is formed on the entire surface by vapor deposition such as deposition. The common electrode 24 has a two-layer structure including an electron injection layer made of a low work function material such as magnesium, calcium, lithium, barium, or a rare-earth metal and a transparent conductive layer containing indium oxide, zinc oxide, tin oxide, or a mixture containing at least one of them (e.g., indium tin oxide (ITO), indium zinc oxide, or cadmium-tin oxide (CTO)). The electron injection layer having a thickness of 10 to 200 nm is so thin that visible light passes through it. Hence, the electron injection layer can be cut by the step of the current source line 18 or EL line 19. The transparent conductive layer of the common electrode 24 is formed across the current source line insulating film 21 on the current source line 18 and across the EL line 19 to set one electrode of each of the organic EL elements 26 of the plurality of pixels at an equipotential. Hence, the light-emitting layer 23 is covered with the common electrode 24 while being in tight contact with the common electrode 24. The EL line 19 is also covered with the common electrode 24 while being in tight contact with the common electrode 24 and electrically connected to the common electrode 24. Referring to FIG. 7, the structure in which the pixel electrode 16a, hole transport layer 22, light-emitting layer 23, and common electrode 24 are stacked in this order serves as the organic EL element 26. The common electrode 24 is formed continuously to cover all pixels (organic EL elements 26).

An overcoat insulating layer 25 is formed on the entire surface by spin coating, dip coating, or vapor deposition. As shown in FIG. 9, the terminals of a scan driver 32 are connected to the ends of the interconnections 36 on the opposite side of the exposed contact holes 37. The terminals of a current control data driver 33 are connected to the exposed ends of the signal current lines 3. The terminals of a current source driver 34 are connected to the current source lines 18 through the interconnections 45. A constant voltage VSS output from the scan driver 32 and current source driver 34 is applied to the common electrode 24 through the interconnections 36 and 39, common interconnections 35 and 38, and EL lines 19. The upper surface of the substrate 2 may be covered with a transparent sealing substrate such that the organic EL elements 26 are sealed by the substrate 2 and transparent sealing substrate. In this way, an active matrix driving display device is completed.

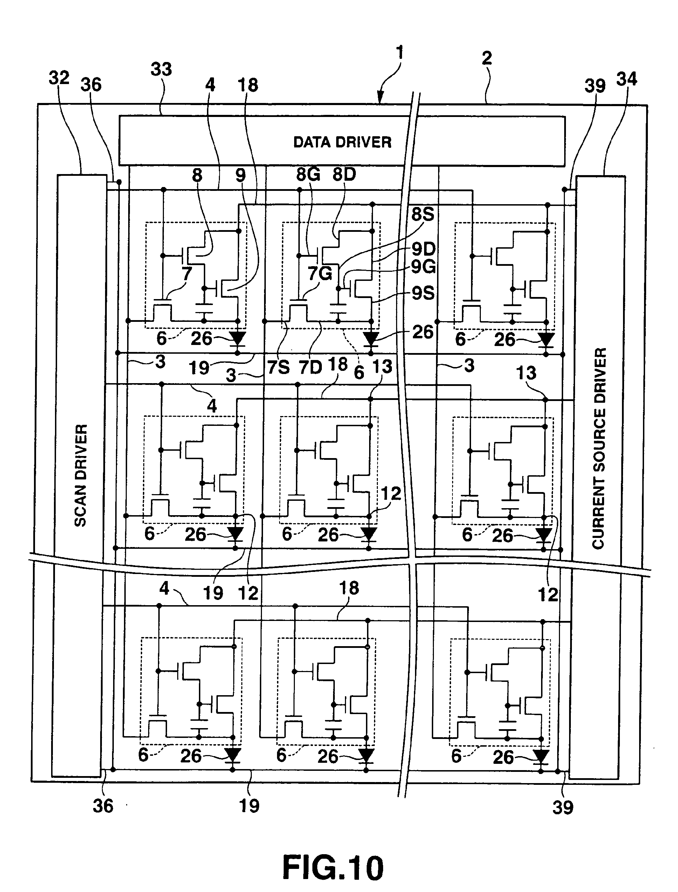

The completed display device comprises circuits shown in FIG. 10. As shown in FIG. 10, the current control transistor 9 and organic EL element 26 are connected in series between the current source line 18 and the EL line 19. More specifically, the drain 9D of the current control transistor 9 is connected to the current source line 18. The source 9S of the current control transistor 9 is connected to the pixel electrode 16a serving as the anode of the organic EL element 26. The common electrode 24 serving as the cathode of the organic EL element 26 is connected to the EL line 19. The EL line 19 corresponds to the conductive layer of the light-emitting element connecting interconnection. The plurality of organic EL elements 26 arrayed in the same row along the scanning line 4 are connected to the same EL line 19.

An example of the driving method of the electroluminescent display panel will be described.

The scan driver 32 sequentially outputs a shift pulse of ON level (high level) to the plurality of scanning lines 4. In synchronism with this, the current source driver 34 sequentially outputs a shift pulse of low level (potential equal to or lower than the constant voltage VSS of the EL lines 19) to the plurality of current source lines 18. While the shift pulse is output to the scanning lines 4, the data driver 33 forcibly supplies a storage current (pull-out current) having a current value corresponding to the luminance gray level to the path between the drain 9D and source 9S of the current control transistor 9 through the signal current line 3 and the path between the drain 7D and source 7S of the current path control transistor 7 connected to the current control transistor 9.

More specifically, during the selection period of a given row, a shift pulse of high level is output to the scanning line 4 of the row, and a voltage of OFF level (low level) is applied to the plurality of scanning lines 4 except the row. At this time, a shift pulse of low level equal to or lower than the constant voltage VSS of the EL line 19 is output to the current source line 18 of the row. The current path control transistor 7 and holding transistor 8 are turned on (selected). At this time, the data driver 33 controls to forcibly supply a storage current having a current value corresponding to gray level data to the path between the drain 9D and source 9S of the current control transistor 9. The storage current flows from the current source line 18 to the signal current line 3 through the path between the drain 9D and source 9S of the current control transistor 9 and the path between the drain 7D and source 7S of the current path control transistor 7. The current value of the storage current is automatically controlled by the data driver 33 in accordance with the light emission luminance gray level of the organic EL element 26.

Because of the characteristics of a transistor, the current value of the current flowing to the path between the drain 9D and source 9S of the current control transistor 9 depends on the potential between the gate 9G and source 9S of the current control transistor 9 and the potential between the drain 9D and source 9S of the current control transistor 9. The data driver 33 sets the potential between the gate 9G and source 9S of the current control transistor 9 and the potential between the drain 9D and source 9S of the current control transistor 9 in accordance with the current value of the storage current. The voltage value between the gate 9G and source 9S at this time is held (stored) during the subsequent light emission period by charges accumulated in the capacitor 10 between the gate 9G and source 9S of the current control transistor 9. During the light emission period after the selection period of the row, the scan driver 32 changes the scanning line 4 of the row to OFF level so that the current path control transistor 7 and holding transistor 8 are turned off. The charges in the capacitor 10 are held by the holding transistor 8 in the OFF state, and the voltage between the gate 9G and source 9S of the current control transistor 9 is maintained. When the current source line 18 changes to high level (level higher than the voltage of the EL line 19), a potential difference enough to saturate the path between the drain 9D and source 9S of the current control transistor 9 is generated. Hence, a driving current whose current value is uniquely determined by the magnitude of the voltage between the gate 9G and source 9S of the current control transistor 9 flows from the current source line 18 to the organic EL element 26 through the current control transistor 9. The organic EL element 26 emits light in accordance with the current value of the driving current. The magnitude of the driving current depends on the voltage between the gate 9G and source 9S of the current control transistor 9. For this reason, the current value of the driving current during the light emission period is uniquely determined by the current value of the storage current during the selection period. When the selection period and light emission period are shifted for each row, the electroluminescent display panel can execute frame display.

As described above, the current value of the storage current pulled out by the signal current line 3 almost equals the current value of the driving current flowing to one organic EL element 26. Hence, the signal current line 3 can be set to such a resistance that the signal current line 3 can sufficiently function even when the same film as the sources and drains of the transistors 7, 8, and 9 is used. Since the scanning line 4 only needs to ON/OFF-control the current path control transistor 7 and holding transistor 8 by voltage modulation, a large current need not always be supplied to the scanning line 4. For this reason, the scanning line 4 can be set to such a resistance that the scanning line 4 can sufficiently function even when the same film as the gates of the transistors 7, 8, and 9 is used.

However, the current source line 18 of a given row must have a low resistance to flow a current having a large current value because the current source line 18 serves as the current source of the driving currents to be supplied to the organic EL elements 26 of the plurality of pixels of the row during the light emission period of the row. The EL line 19 of a given row must have a low resistance to flow a current having a large current value because the driving currents to be supplied to the organic EL elements 26 of the plurality of pixels of the row flow together to the EL line 19 during the light emission period of the row. The resistances of the current source line 18 and EL line 19 must be reduced as the number of pixels (the number of organic EL elements 26) of each row increases. When the number of pixels is sufficiently large, the current cannot be sufficiently be supplied by using the same film as the gates of the transistors 7, 8, and 9.

In this embodiment, the current source line 18 and EL line 19 are formed from a conductive film different from that forming part of the transistors 7, 8, and 9. For this reason, the current source line 18 and EL line 19 can be deposited thicker than the sources 7S, 8S, and 9S and drains 7D, 8D, and 9D of the transistors 7, 8, and 9. Hence, the resistance per unit length can be set to be lower than the sources 7S, 8S, and 9S and drains 7D, 8D, and 9D. In addition, the current source line 18 and EL line 19 can be deposited thicker than the gates 7G, 8G, and 9G of the transistors 7, 8, and 9. Hence, the resistance per unit length can be set to be lower than the gates 7G, 8G, and 9G. For these reasons, the electrical resistances of the current source line 18 and EL line 19 can be set low. The time delay from the start of the light emission period until the organic EL element 26 emits light of desired brightness (gray level) can be suppressed. The voltage drop in the current source line 18 and EL line 19 can be suppressed. Furthermore, since the resistances of the current source line 18 and EL line 19 are low, any decrease in brightness, variation in brightness, and display degradation such as crosstalk in the electroluminescent display panel can be suppressed.

For example, assume that the current source line 18 and EL line 19 are set to an interconnection width of 20 µm and an interconnection length of 664 nm, and copper with a thickness of 5 µm is used, as in the present invention. In this case, the sheet resistance is 0.003 Ω/□, and the resistance is 111 Ω. At 40 mA, the voltage drop is suppressed to 4.4 V. On the other hand, assume that Al-Ti having a thickness of 0.3 µm, which is used for the drains and sources of the transistors 7, 8, and 9, is used as the current source line 18 and EL line 19, as in the prior art. In this case, the sheet resistance is 0.5 Ω/□, and the resistance is 16,600 Ω. At 40 mA, the voltage drop is 6,644 V.

The present invention is not limited to the above embodiment, and various changes and modifications in design can be made without departing from the spirit and scope of the present invention.

For example, a contact hole may be provided in the gate insulating film 41 and planarizing film 11 to expose the scanning line 4 except the portion crossing the signal current line 3. A plating layer may be formed on the scanning line 4 in the same process as film formation of the current source line 18 and EL line 19 to reduce the resistance of the scanning line 4. To insulate the plating layer from the common electrode 24, an insulating film is inserted between the plating layer and the common electrode 24, like the current source line insulating film 21 of the current source line 18. The plating layer is electrically connected to the gates of the transistors 7 and 8.

In the above embodiment, the transistors 7, 8, and 9 are n-channel thin-film transistors. The transistors 7, 8, and 9 may be p-channel thin-film transistors. When the transistors 7, 8, and 9 are p-channel thin-film transistors, connection of the source and drain reverses. In the description, "source" is changed to "drain", and "drain" is changed to "source". "High level" of a signal is changed to "low level", and "low level" is changed to "high level". Even in this case, the direction of the storage current does not change.

### [Second Embodiment]

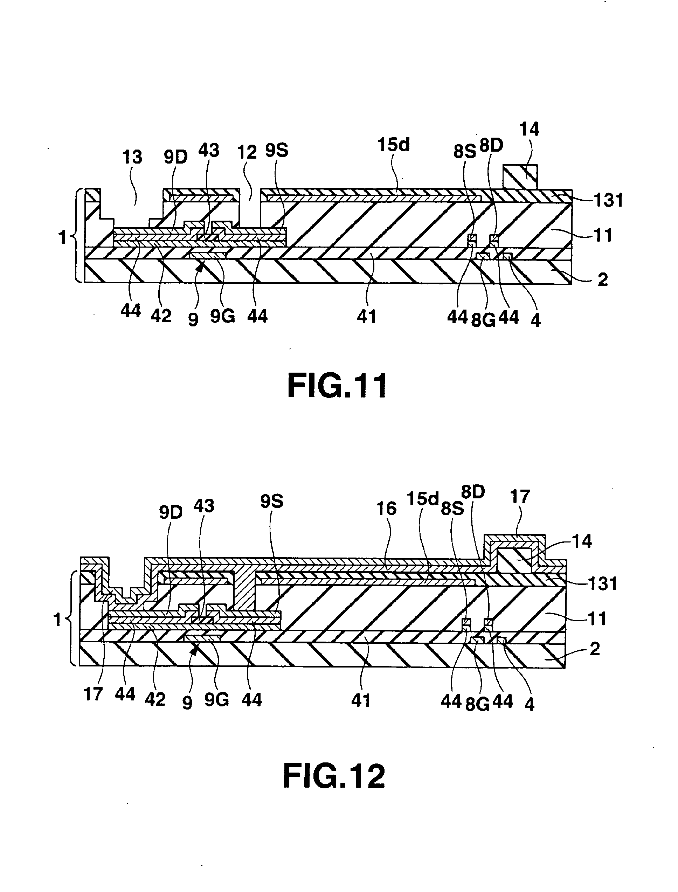

A method of manufacturing a display device according to the second embodiment will be described with reference to FIGS. 11 to 16. FIGS. 11 to 16 are sectional views of steps in the manufacturing method. The steps are executed in the order of FIGS. 11 to 16. The same reference numerals as in the display device of the first embodiment denote the same parts in FIGS. 11 to 16, and some of the same steps as in the first embodiment are not illustrated.

As shown in FIG. 11, a transistor array substrate 1 is manufactured. A reflecting metal film 15d is patterned on a planarizing film 11 for each pixel by executing a reflecting metal film forming process such as vapor deposition, a mask process such as photolithography, and a shaping process such as etching in this order.

A transparent insulating film 131 is formed on the entire surface by vapor deposition to cover the reflecting metal film 15d. The reflecting metal film 15d is electrically insulated by the transparent insulating film 131. The second embodiment is different from the first embodiment in that the transparent insulating film 131 is formed.

Photolithography and etching are executed to form, in the planarizing film 11 and transparent insulating film 131, a contact hole 12 communicating with a source 9S of each current control transistor 9 and a contact hole 13 communicating with a drain 9D of each current control transistor 9. An organic EL isolation insulating film 14 made of silicon nitride or silicon oxide is patterned to be parallel to scanning lines 4 between pixels adjacent in the longitudinal direction.

As shown in FIG. 12, a transparent metal oxide film 16 is formed on the entire surface of the transparent insulating film 131 by vapor deposition. The transparent metal oxide film 16 is formed on the surface even in the contact holes 12 and 13 and contacts the drain 9D and source 9S of the current control transistor 9. The second embodiment is different from the first embodiment in that the reflecting metal film 15d is electrically disconnected from the transparent metal oxide film 16 by the transparent insulating film 131.

A metal layer 17 made of a metal material such as copper or nickel is formed on the entire surface of the transparent metal oxide film 16 by vapor deposition such as sputtering. A photoresist film 62 is formed while exposing the metal layer 17 at a portion which overlaps the contact hole 13 along the row direction and the metal layer 17 at a portion which overlaps the organic EL isolation insulating film 14 along the row direction. Like the photoresist film 61 of the first embodiment, the photoresist film 62 exposes the metal layer 17 connected to interconnections 36 through contact holes 37, the metal layer 17 connected to interconnections 39 through contact holes 40, and the metal layer 17 connected to interconnections 45 through contact holes 46.

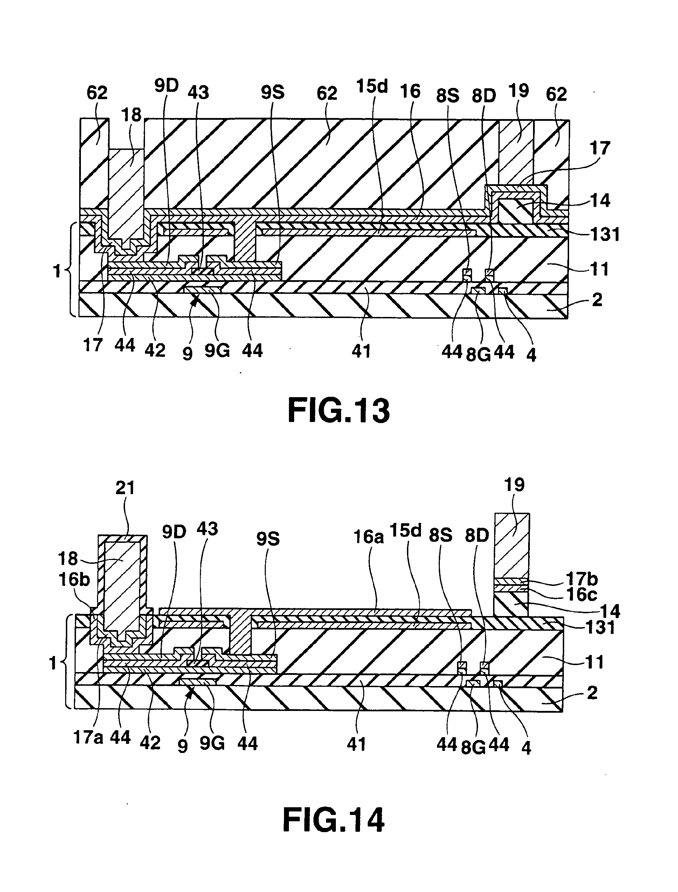

When electroplating is executed, a current source line 18 and EL line 19 made of a thick copper plating film having a thickness of 2 to 100 µm, i.e., thicker than the sources, drains, and gates of transistors 7, 8, and 9, and a width of 5 to 50 µm are formed on the exposed metal layers 17, as shown in FIG. 13. The drains 9D of the current control transistors 9 of the plurality of pixels arrayed in the row direction are electrically connected to the common current source line 18. The copper thick film may be formed by sputtering or sublimation deposition in place of electroplating. The number of current source line 18 and the number of EL line 19 equal the number of scanning lines 4. Each row has one current source line 18, one EL line 19, and one scanning line 4.

As shown in FIG. 14, after the photoresist film 62 is removed, the exposed metal layers 17 are removed by etching by using the current source line 18 and EL line 19 as a mask to form an underlayer 17a under the current source line 18 and an underlayer 17b under the EL line 19. In addition, photolithography and etching are executed for the transparent metal oxide film 16 to pattern a pixel electrode 16a. In addition, the transparent metal oxide film 16 provided under the underlayer 17a is left by using the current source line 18 as a mask to form a transparent metal oxide underlying film 16b. The transparent metal oxide film 16 provided under the underlayer 17b is left to form a transparent metal oxide underlying film 16c.

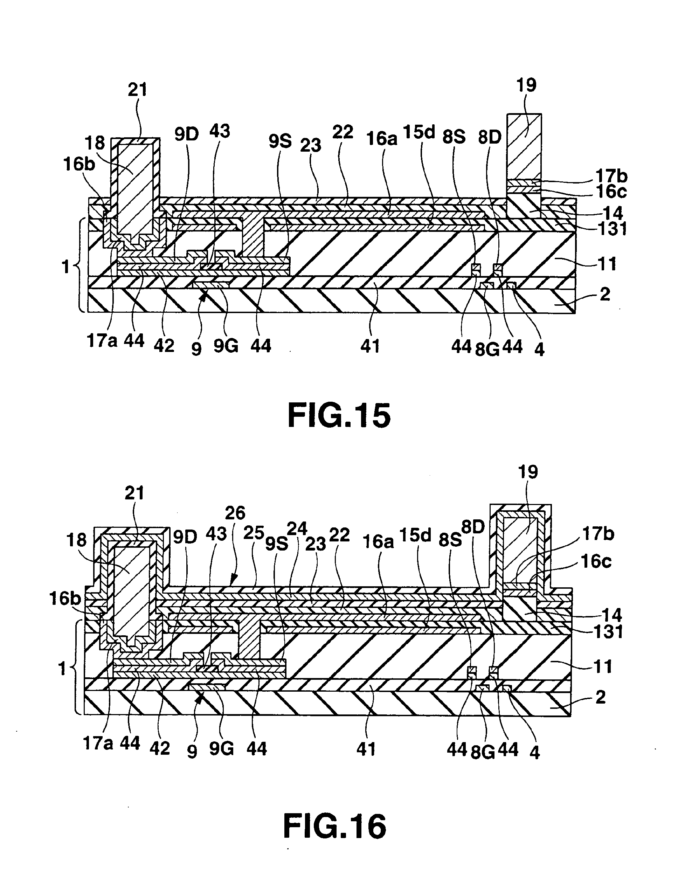

A current source line insulating film 21 is patterned to cover only the current source line 18. As shown in FIG. 15, a hole transport layer 22 made of polythiophene (PEDOT) and polystyrene sulfonate (PSS) as a dopant is formed by wet film formation such as droplet discharge (ink jet), spin coating, dip coating, or dropping by a needle. The hole transport layer 22 may be formed on the entire surface of the transistor array substrate 1 and shared by all pixels. Alternatively, the hole transport layer 22 may be formed independently for each pixel. FIG. 15 shows a state in which after the region surrounded by the current source line 18 and EL line 19 is filled with a solution or suspension containing the material of the hole transport layer 22, the solvent or water volatilizes to form the hole transport layer 22.

After the hole transport layer 22 is dried, a light-emitting layer 23 made of polyfluorene-based light-emitting material is patterned for each pixel by wet film formation such as droplet discharge (ink jet) or dropping by a needle, as in the first embodiment. The transparent metal oxide underlying film 16c, underlayer 17b, and EL line 19 remain on the organic EL isolation insulating film 14. The hole transport layer 22 and light-emitting layer 23 are thinner than the organic EL isolation insulating film 14. The height of the solution or suspension as the prospective hole transport layer 22 and the height of the solution or suspension as the prospective light-emitting layer 23 which covers the pixel region are smaller than the height of the current source line 18 and the height of the EL line 19. Hence, the solution or suspension as the prospective hole transport layer 22 and the solution or suspension as the prospective light-emitting layer 23 do not flow to a pixel of an adjacent row over the current source line 18 and EL line 19. That is, the current source line 18 and EL line 19 function as partitions to prevent any outflow of the solution or suspension as the prospective hole transport layer 22 and the solution or suspension as the prospective light-emitting layer 23. Hence, as shown in FIG. 9, when a plurality of pixels in the row direction surrounded along the current source line 18 and EL line 19 should have light-emitting layers which emit the same color light, the light-emitting layers 23 for the plurality of pixels in the row direction can be formed at once by supplying the solution or suspension for the light-emitting layer 23 between the current source line 18 and the EL line 19.

As shown in FIG. 16, a common electrode 24 serving as a cathode electrode is formed on the entire surface by vapor deposition such as deposition. The common electrode 24 has a two-layer structure including an electron injection layer made of a low work function material such as magnesium, calcium, lithium, barium, or a rare-earth metal and a transparent conductive layer containing indium oxide, zinc oxide, tin oxide, or a mixture containing at least one of them (e.g., indium tin oxide (ITO), indium zinc oxide, or cadmium-tin oxide (CTO)). The electron injection layer having a thickness of 10 to 200 nm is so thin that visible light passes through it. Hence, the electron injection layer can be cut by the step of the current source line 18 or EL line 19. The transparent conductive layer of the common electrode 24 is formed across the current source line insulating film 21 on the current source line 18 and across the EL line 19 to set one electrode of each of organic EL elements 26 of the plurality of pixels at an equipotential. Hence, the light-emitting layer 23 is covered with the common electrode 24 while being in tight contact with the common electrode 24. The EL line 19 is also covered with the common electrode 24 while being in tight contact with the common electrode 24 so that the organic EL element 26 is formed.

An overcoat insulating layer 25 is formed on the entire surface by spin coating, dip coating, or vapor deposition. A scan driver 32, data driver 33, and current source driver 34 are connected, and a transparent sealing substrate is bonded.

With the above process, an active matrix driving electroluminescent display panel is completed.

Even in the second embodiment, the current source line 18 and EL line 19 are formed from a conductive film different from that forming part of the transistors 7, 8, and 9. For this reason, the current source line 18 and EL line 19 can be formed thicker than the drains, sources, and gates of the transistors 7, 8, and 9, a signal current line 3, and the scanning line 4, and the resistance per unit length can be reduced. Hence, the electrical resistances of the current source line 18 and EL line 19 can be set low. The time delay from the start of the light emission period until the organic EL element 26 emits light of desired brightness (gray level) can be suppressed. The voltage drop in the current source line 18 and EL line 19 can be suppressed. Furthermore, since the resistances of the current source line 18 and EL line 19 are low, any decrease in brightness, variation in brightness, and display degradation such as crosstalk in the electroluminescent display panel can be suppressed.

### [Third Embodiment]

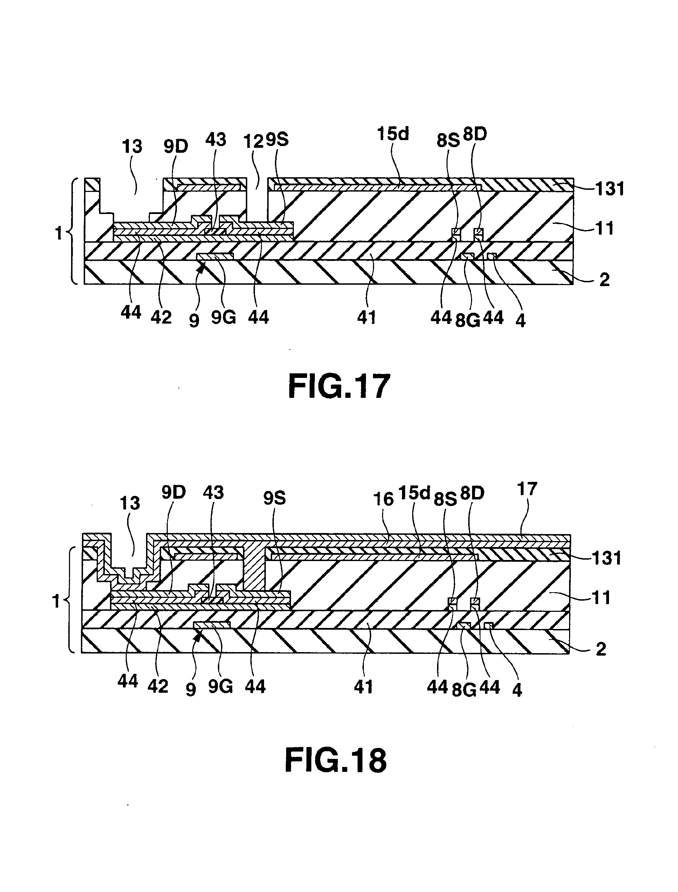

A method of manufacturing an electroluminescent display panel according to the third embodiment will be described with reference to FIGS. 17 to 22. FIGS. 17 to 22 are sectional views of steps in the manufacturing method. The steps are executed in the order of FIGS. 17 to 22. The same reference numerals as in the electroluminescent display panel of the second embodiment denote the same parts in FIGS. 17 to 22, and some of the same steps as in the first embodiment are not illustrated.

As shown in FIG. 17, a transistor array substrate 1 is manufactured. A reflecting metal film 15d is patterned on a planarizing film 11 for each pixel by executing a reflecting metal film forming process such as vapor deposition including sputtering, a mask process such as photolithography, and a shaping process such as etching in this order.

A transparent insulating film 131 is formed on the entire surface by vapor deposition to cover the reflecting metal film 15d. The reflecting metal film 15d is electrically insulated by the transparent insulating film 131.

Photolithography and etching are executed to form, in the planarizing film 11 and transparent insulating film 131, a contact hole 12 communicating with a source 9S of each current control transistor 9 and a contact hole 13 communicating with a drain 9D of each current control transistor 9.

In the second embodiment, the organic EL isolation insulating film 14 is patterned. In the third embodiment, however, no organic EL isolation insulating film is patterned.

As shown in FIG. 18, a transparent metal oxide film 16 is formed on the entire surface of the transparent insulating film 131 by vapor deposition. The transparent metal oxide film 16 is formed on the surface even in the contact holes 12 and 13 and contacts the drain 9D and source 9S of the current control transistor 9.

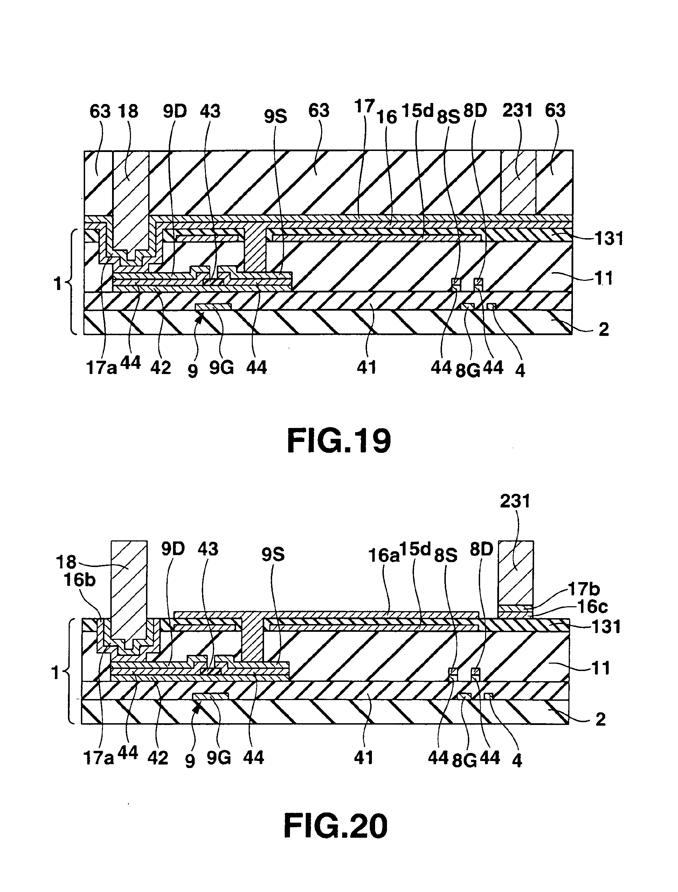

As shown in FIG. 19, a metal layer 17 made of a metal material such as copper or nickel is formed on the entire surface of the transparent metal oxide film 16 by vapor deposition. A photoresist film 63 is formed while exposing a portion 17a of the metal layer 17, which overlaps the contact hole 13 along the row direction, and a portion 17b where a partition 231 along the row direction is to be formed on a side opposing the portion 17a with respect to the reflecting metal film 15d. Like the photoresist film 61 of the first embodiment, the photoresist film 63 exposes the metal layer 17 connected to interconnections 36 through contact holes 37, the metal layer 17 connected to interconnections 39 through contact holes 40, and the metal layer 17 connected to interconnections 45 through contact holes 46.

When electroplating is executed, a current source line 18 and partition 231 made of a thick copper plating film having a thickness of 2 to 100 µm, i.e., thicker than the sources, drains, and gates of transistors 7, 8, and 9, and a width of 5 to 50 µm are formed on the exposed underlayers 17a and 17b. The drains 9D of the current control transistors 9 of the plurality of pixels arrayed in the row direction are electrically connected to the common current source line 18. The copper thick film may be formed by sputtering or sublimation deposition in place of electroplating.

In patterning the current source line 18 and partition 231, the current source line 18 is provided in parallel to the partition 231, and the current source line 18 and partition 231 are provided in parallel to a scanning line 4. The current source line 18 is patterned such that it overlaps the contact holes 13 of all pixels arrayed in the lateral direction (row direction) when viewed from the upper side. In addition, the current source line 18 is patterned such that it runs up to the edge of the transistor array substrate 1.

As shown in FIG. 20, after the photoresist film 63 is removed, the exposed metal layers 17 are removed by etching by using the current source line 18 and partition 231 as a mask to leave the underlayer 17a under the current source line 18 and the underlayer 17b under the partition 231. In addition, photolithography and etching are executed for the transparent metal oxide film 16 to pattern a pixel electrode 16a. In addition, the transparent metal oxide film 16 provided under the underlayer 17a is left by using the current source line 18 as a mask to form a transparent metal oxide underlying film 16b. The transparent metal oxide film 16 provided under the underlayer 17b is left to form a transparent metal oxide underlying film 16c.

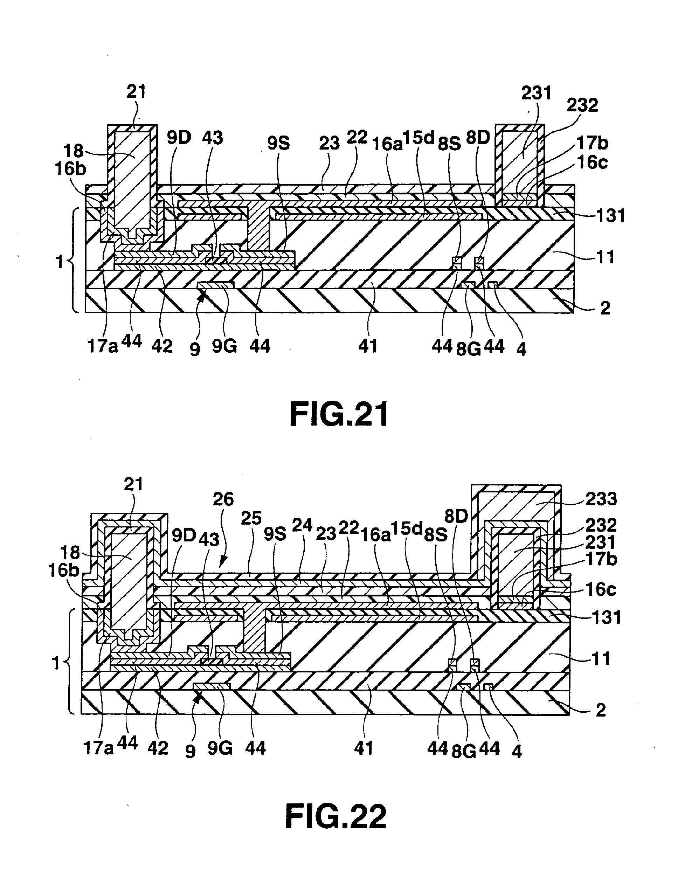

As shown in FIG. 21, a current source line insulating film 21 is formed to cover the current source line 18. An EL line insulating film 232 made of the same material as the current source line insulating film 21 is formed in the same process as the current source line insulating film 21 to cover the partition 231. With the above process, an organic EL driving substrate is completed.

A hole transport layer 22 made of polythiophene (PEDOT) and polystyrene sulfonate (PSS) as a dopant is formed by wet film formation such as droplet discharge (ink jet), spin coating, dip coating, or dropping by a needle. The hole transport layer 22 may be formed on the entire surface of the transistor array substrate 1 and shared by all pixels. Alternatively, the hole transport layer 22 may be formed independently for each pixel. FIG. 21 shows a state in which after the region surrounded by the current source line 18 and partition 231 is filled with a solution or suspension containing the material of the hole transport layer 22, the solvent or water volatilizes to form the hole transport layer 22.

After the hole transport layer 22 is dried, a light-emitting layer 23 made of polyfluorene-based light-emitting material is patterned for each pixel by wet film formation such as droplet discharge (ink jet) or dropping by a needle, as in the first embodiment. The hole transport layer 22 and light-emitting layer 23 are thinner than the partition 231. The height of the solution or suspension as the prospective hole transport layer 22 and the height of the solution or suspension as the prospective light-emitting layer 23 which covers the pixel region are smaller than the height of the current source line 18 and the height of the partition 231. Hence, the solution or suspension as the prospective hole transport layer 22 and the solution or suspension as the prospective light-emitting layer 23 do not flow to a pixel of an adjacent row over the current source line 18 and partition 231. That is, the current source line 18 and partition 231 function as partitions to prevent any outflow of the solution or suspension as the prospective hole transport layer 22 and the solution or suspension as the prospective light-emitting layer 23. Hence, when a plurality of pixels in the row direction surrounded along the current source line 18 and partition 231 should have light-emitting layers which emit the same color light, the light-emitting layers 23 for the plurality of pixels in the row direction can be formed at once by supplying the solution or suspension for the light-emitting layer 23 between the current source line 18 and the partition 231.

As shown in FIG. 22, a common electrode 24 serving as a cathode electrode is formed on the entire surface by vapor deposition such as deposition. The common electrode 24 has a two-layer structure including an electron injection layer made of a low work function material such as magnesium, calcium, lithium, barium, or a rare-earth metal and a transparent conductive layer containing indium oxide, zinc oxide, tin oxide, or a mixture containing at least one of them (e.g., indium tin oxide (ITO), indium zinc oxide, or cadmium-tin oxide (CTO)). The electron injection layer having a thickness of 10 to 200 nm is so thin that visible light passes through it. Hence, the electron injection layer can be cut by the step of the current source line 18 or partition 231. The transparent conductive layer of the common electrode 24 is formed across the current source line insulating film 21 on the current source line 18 and across the EL line insulating film 232 on the surface of the partition 231 to set one electrode of each of organic EL elements 26 of the plurality of pixels at an equipotential. Hence, the light-emitting layer 23 is covered with the common electrode 24 while being in tight contact with the common electrode 24. The partition 231 is also covered with the common electrode 24 while being in tight contact with the common electrode 24 so that the organic EL element 26 is formed. The partition 231 is used to partition the solution or suspension containing the material of the hole transport layer 22 and/or the solution or suspension containing the material of the light-emitting layer 23 at a predetermined position. No voltage is applied to the partition 231, unlike the EL line 19 of the first embodiment.

An EL line 233 thicker than the sources, drains, and gates of the transistors 7, 8, and 9 is formed on the common electrode 24 by deposition, sputtering, screen printing, sublimation deposition, or dispenser method such that the EL line 233 overlaps the partition 231 when viewed from the upper side. The EL line 233 corresponds to the EL line 19 of the first embodiment and has the same shape, length, and thickness as the EL line 19. Since the EL line 233 is thicker than sources 7S, 8S, and 9S, drains 7D, 8D, and 9D, and gates 7G, 8G, and 9G of the transistors 7, 8, and 9, the resistance per unit interconnection length is set lower than that of these electrodes. The EL line 233 may be deposited by electroplating by using a photoresist film 61, like the EL line 19 of the first embodiment. The EL line 233 is connected to the common electrode 24 common to all pixels above the partition 231. The number of current source line 18 and the number of EL lines 233 equal the number of scanning lines 4. Each row has one current source line 18, one EL line 233, and one scanning line 4.

An overcoat insulating layer 25 is formed on the entire surface by spin coating, dip coating, or vapor deposition. A scan driver 32, data driver 33, and current source driver 34 are connected, and a transparent sealing substrate is bonded.

With the above process, an active matrix driving display device is completed.

Even in the third embodiment, the current source line 18 and EL line 233 are formed from a conductive film different from that forming part of the transistors 7, 8, and 9. For this reason, the current source line 18 and EL line 233 can be formed thicker than the drains, sources, and gates of the transistors 7, 8, and 9, a signal current line 3, and the scanning line 4. Hence, the electrical resistances of the current source line 18 and EL line 233 can be set low. The time delay from the start of the light emission period until the organic EL element 26 emits light of desired brightness (gray level) can be suppressed. The voltage drop in the current source line 18 and EL line 233 can be suppressed. Furthermore, since the resistances of the current source line 18 and EL line 233 are low, any decrease in brightness, variation in brightness, and display degradation such as crosstalk in the electroluminescent display panel can be suppressed.

### [Fourth Embodiment]

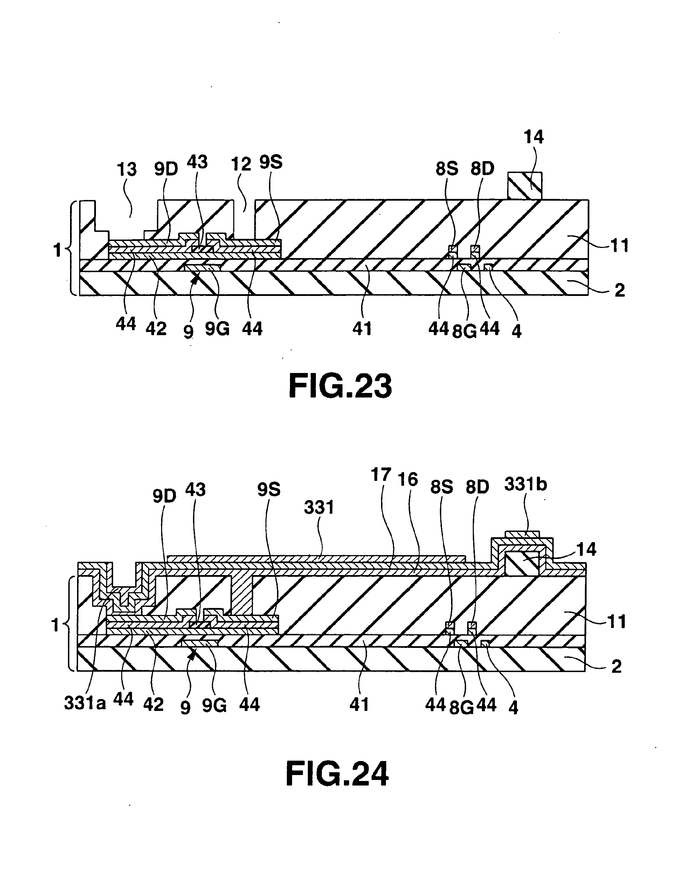

A method of manufacturing an electroluminescent display panel according to the fourth embodiment will be described with reference to FIGS. 23 to 28. FIGS. 23 to 28 are sectional views of steps in the manufacturing method. The steps are executed in the order of FIGS. 23 to 28. The same reference numerals as in the electroluminescent display panel of the first embodiment denote the same parts in FIGS. 23 to 28, and some of the same steps as in the first embodiment are not illustrated.

As shown in FIG. 23, a transistor array substrate 1 is manufactured. Photolithography and etching are executed for the prepared transistor array substrate 1 to form, in a planarizing film 11, a contact hole 12 communicating with a source 9S of each current control transistor 9 and a contact hole 13 communicating with a drain 9D of each current control transistor 9.

An organic EL isolation insulating film 14 made of silicon nitride or silicon oxide is formed by patterning to be parallel to scanning lines 4 between pixels adjacent in the longitudinal direction (column direction).

As shown in FIG. 24, a transparent metal oxide film 16 is formed on the entire surface of the transistor array substrate 1 by vapor deposition. In the first embodiment, the reflecting metal film 15 is formed before the transparent metal oxide film 16. In the fourth embodiment, however, no reflecting metal film 15 is formed. A metal layer 17 made of a metal material such as copper or nickel is formed on the entire surface of the transparent metal oxide film 16 by vapor deposition.

A mask is patterned by photolithography. A gold film is formed by a method such as deposition. The mask is peeled to form a pixel electrode 331 made of the gold thin film. In patterning the pixel electrode 331, the mask is formed such that underlying films 331a and 331b remain respectively at a portion corresponding to a current source line 18 (to be described later), i.e., a portion which overlaps the contact hole 13 and runs in the row direction and a portion corresponding to an EL line 19, i.e., a portion which overlaps the organic EL isolation insulating film 14 and runs in the row direction.

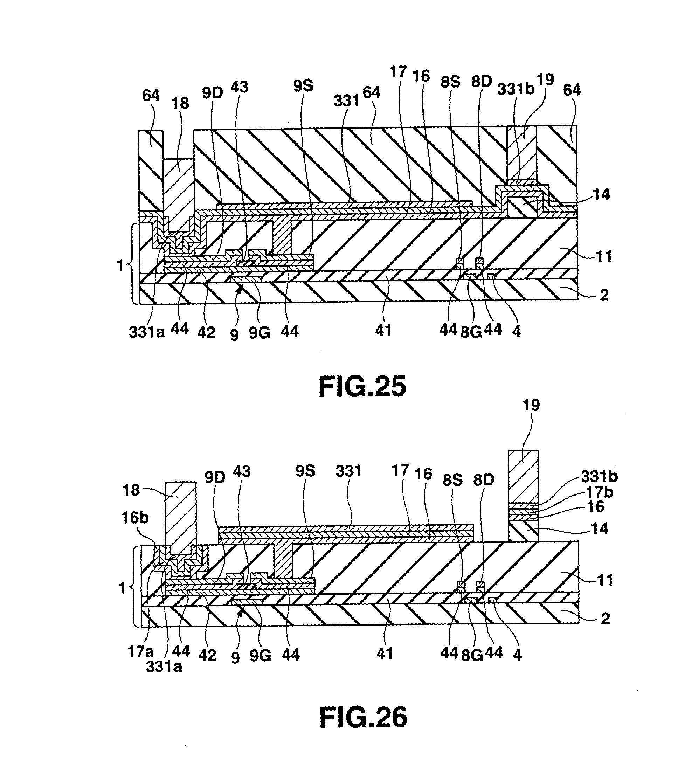

As shown in FIG. 25, a photoresist film 64 is formed while exposing the underlying film 331a at the portion which overlaps the contact hole 13 along the row direction and the underlying film 331b at the portion which overlaps the organic EL isolation insulating film 14 along the row direction. When electroplating is executed by using the exposed underlying films 331a and 331b as electrodes, the current source line 18 and EL line 19 made of a thick copper plating film having a thickness of 2 to 100 µm and a width of 5 to 50 µm are formed on the underlying films 331a and 331b. The current source line 18 and EL line 19 are deposited thicker than sources 7S, 8S, and 9S, drains 7D, 8D, and 9D, and gates 7G, 8G, and 9G of transistors 7, 8, and 9. The resistance per unit interconnection length of the current source line 18 and EL line 19 is set lower than that of these electrodes. The number of current source line 18 and the number of EL line 19 equal the number of scanning lines 4. Each row has one current source line 18, one EL line 19, and one scanning line 4. After that, the photoresist film 64 is removed. The copper thick film may be formed by sputtering, sublimation deposition, or dispenser method in place of electroplating.

As shown in FIG. 26, the exposed metal layers 17 are etched except the portions covered with the current source line 18 and EL line 19 to form an underlayer 17a under the current source line 18 and an underlayer 17b under the EL line 19. The transparent metal oxide film 16 is etched by using the current source line 18, EL line 19, and pixel electrode 331 as a mask to form a transparent metal oxide underlying film 16b, transparent metal oxide underlying film 16c, and transparent metal oxide underlying film or auxiliary electrode line 16d.

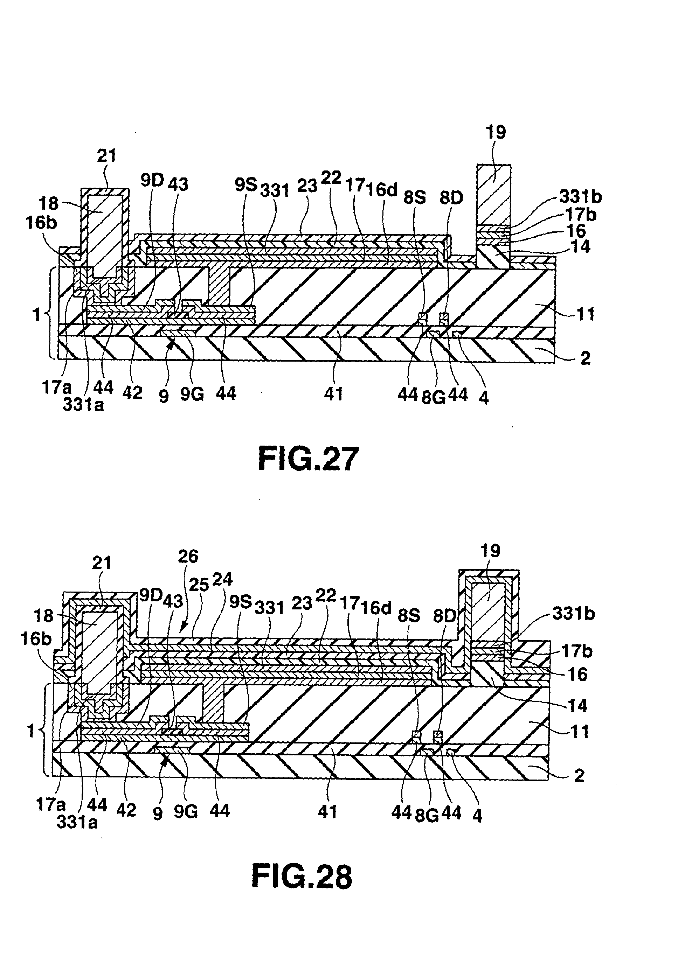

As shown in FIG. 27, a current source line insulating film 21 is formed to cover the current source line 18. With the above process, an organic EL driving substrate is completed.

A hole transport layer 22 made of polythiophene (PEDOT) and polystyrene sulfonate (PSS) as a dopant is formed by wet film formation such as droplet discharge (ink jet), spin coating, dip coating, or dropping by a needle. The hole transport layer 22 may be formed on the entire surface of the transistor array substrate 1 and shared by all pixels. Alternatively, the hole transport layer 22 may be formed independently for each pixel. FIG. 27 shows a state in which after the region surrounded by the current source line 18 and EL line 19 is filled with a solution or suspension containing the material of the hole transport layer 22, the solvent or water volatilizes to form the hole transport layer 22.

After the hole transport layer 22 is dried, a light-emitting layer 23 made of polyfluorene-based light-emitting material is patterned for each pixel by wet film formation such as droplet discharge (ink jet) or dropping by a needle. The transparent metal oxide underlying film 16c, underlayer 17b, and EL line 19 remain on the organic EL isolation insulating film 14. The hole transport layer 22 and light-emitting layer 23 are thinner than the organic EL isolation insulating film 14. The height of the solution or suspension as the prospective hole transport layer 22 and the height of the solution or suspension as the prospective light-emitting layer 23 which covers the pixel region are smaller than the height of the current source line 18 and the height of the EL line 19. Hence, the solution or suspension as the prospective hole transport layer 22 and the solution or suspension as the prospective light-emitting layer 23 do not flow to a pixel of an adjacent row over the current source line 18 and EL line 19. That is, the current source line 18 and EL line 19 function as partitions to prevent any outflow of the solution or suspension as the prospective hole transport layer 22 and the solution or suspension as the prospective light-emitting layer 23. Hence, as shown in FIG. 9, when a plurality of pixels in the row direction surrounded along the current source line 18 and EL line 19 should have light-emitting layers which emit the same color light, the light-emitting layers 23 for the plurality of pixels in the row direction can be formed at once by supplying the solution or suspension for the light-emitting layer 23 between the current source line 18 and the EL line 19.

As shown in FIG. 28, a common electrode 24 serving as a cathode electrode is formed on the entire surface by vapor deposition. The common electrode 24 has a two-layer structure including an electron injection layer made of a low work function material such as magnesium, calcium, lithium, barium, or a rare-earth metal and a transparent conductive layer containing indium oxide, zinc oxide, tin oxide, or a mixture containing at least one of them (e.g., indium tin oxide (ITO), indium zinc oxide, or cadmium-tin oxide (CTO)). The electron injection layer having a thickness of 10 to 200 nm is so thin that visible light passes through it. Hence, the electron injection layer can be cut by the step of the current source line 18 or EL line 19. The transparent conductive layer of the common electrode 24 is formed across the current source line insulating film 21 on the current source line 18 and across the EL line 19 to set one electrode of each of organic EL elements 26 of the plurality of pixels at an equipotential.

An overcoat insulating layer 25 is formed on the entire surface by spin coating, dip coating, or vapor deposition. A scan driver 32, data driver 33, and current source driver 34 are connected, and a transparent sealing substrate is bonded.

With the above process, an active matrix driving display device is completed.

A contact hole may be provided in the gate insulating film 41 and planarizing film 11 to expose the scanning line 4 except the portion crossing a signal current line 3. An electroplating layer may be formed on the scanning line 4 in the same process as film formation of the current source line 18 and EL line 19. In this case, to insulate the plating layer from the common electrode 24, an insulating film is inserted between the plating layer and the common electrode 24, like the current source line insulating film 21 of the current source line 18. The plating layer is electrically connected to the gates of the transistors 7 and 8.

Even in the fourth embodiment, the current source line 18 and EL line 19 are formed from a conductive film different from that forming part of the transistors 7, 8, and 9. For this reason, the current source line 18 and EL line 19 can be formed thicker than the drains, sources, and gates of the transistors 7, 8, and 9, the signal current line 3, and the scanning line 4. Hence, the electrical resistances of the current source line 18 and EL line 19 can be set low. The time delay from the start of the light emission period until the organic EL element 26 emits light of desired brightness (gray level) can be suppressed. The voltage drop in the current source line 18 and EL line 19 can be suppressed. Furthermore, since the resistances of the current source line 18 and EL line 19 are low, any decrease in brightness, variation in brightness, and display degradation such as crosstalk in the electroluminescent display panel can be suppressed.

### [Fifth Embodiment]

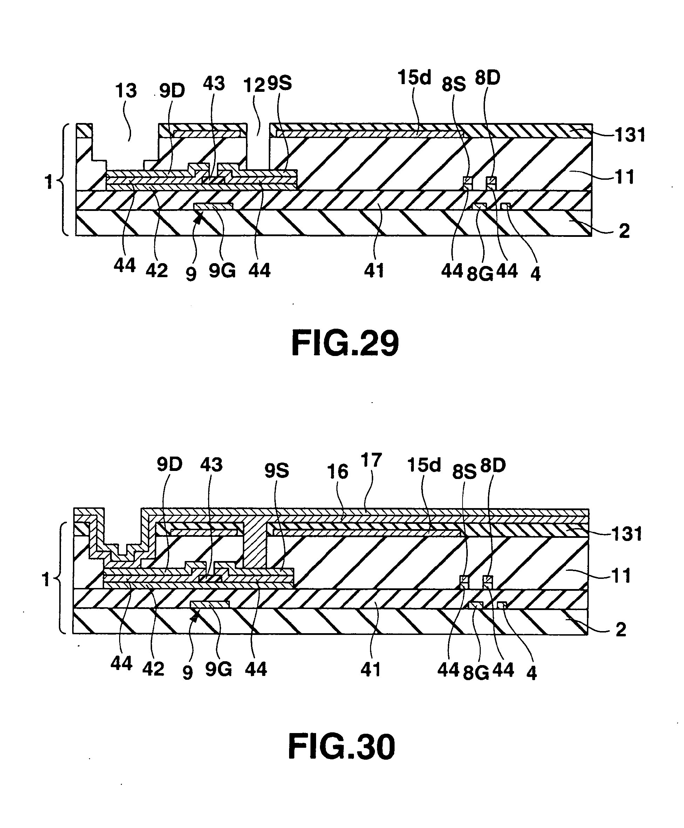

A method of manufacturing an electroluminescent display panel according to the fifth embodiment will be described with reference to FIGS. 29 to 34. FIGS. 29 to 34 are sectional views of steps in the manufacturing method. The steps are executed in the order of FIGS. 29 to 34. The same reference numerals as in the electroluminescent display panel of the second embodiment denote the same parts in FIGS. 29 to 34, and some of the same steps as in the first embodiment are not illustrated.

As shown in FIG. 29, a transistor array substrate 1 is manufactured. A reflecting metal film 15d is patterned for each pixel by executing a forming process such as vapor deposition, a mask process such as photolithography, and a shaping process such as etching in this order.

A transparent insulating film 131 is formed on the entire surface by vapor deposition to cover the reflecting metal film 15d.

Photolithography and etching are executed to form, in the planarizing film 11 and transparent insulating film 131, a contact hole 12 communicating with a source 9S of each current control transistor 9 and a contact hole 13 communicating with a drain 9D of each current control transistor 9.

The fifth embodiment is different from the second embodiment in that the organic EL isolation insulating film 14 of the second embodiment is not formed.

As shown in FIG. 30, a transparent metal oxide film 16 is formed on the entire surface of the transparent insulating film 131 by vapor deposition. The transparent metal oxide film 16 is formed on the surface even in the contact holes 12 and 13 and contacts the drain 9D and source 9S of the current control transistor 9.

A metal layer 17 made of a metal material such as copper or nickel is formed on the entire surface of the transparent metal oxide film 16 by vapor deposition such as sputtering.

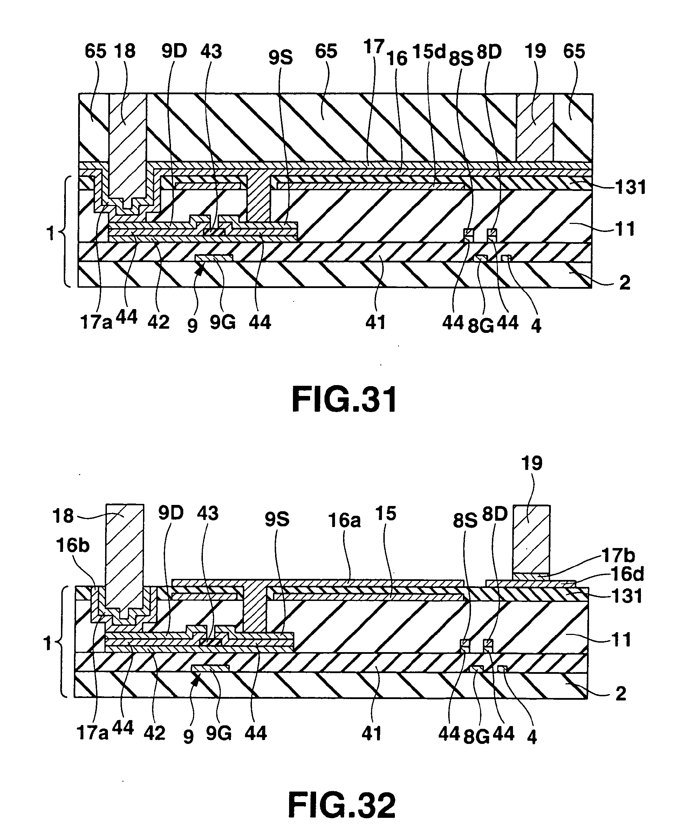

As shown in FIG. 31, a photoresist film 65 is formed while exposing a portion 17a of the metal layer 17, which overlaps the contact hole 13 along the row direction, and a portion 17b where an EL line 19 along the row direction is to be formed on a side opposing the portion 17a with respect to the reflecting metal film 15d. When electroplating is executed, a current source line 18 and EL line 19 made of a thick copper plating film having a thickness of 2 to 100 µm, i.e., thicker than the sources, drains, and gates of transistors 7, 8, and 9, and a width of 5 to 50 µm are formed on the exposed underlayer portions 17a and 17b. The drains 9D of the current control transistors 9 of the plurality of pixels arrayed in the row direction are electrically connected to the common current source line 18. The copper thick film may be formed by sputtering or sublimation deposition in place of electroplating. Hence, the current source line 18 and EL line 19 are provided in parallel to a scanning line 4.

After the photoresist film 65 is removed, the exposed metal layers 17 are removed by etching by using the current source line 18 and EL line 19 as a mask to leave the underlayer 17a under the current source line 18 and the underlayer 17b under the EL line 19, as shown in FIG. 32. In addition, photolithography and etching are executed for the transparent metal oxide film 16 to form a pixel electrode 16a by patterning. In addition, the transparent metal oxide film 16 provided under the underlayer 17a is left by using the current source line 18 as a mask to form a transparent metal oxide underlying film 16b. The transparent metal oxide film 16 provided under the underlayer 17b is left to form an auxiliary electrode line 16d. The auxiliary electrode line 16d is preferably wider than the EL line 19.

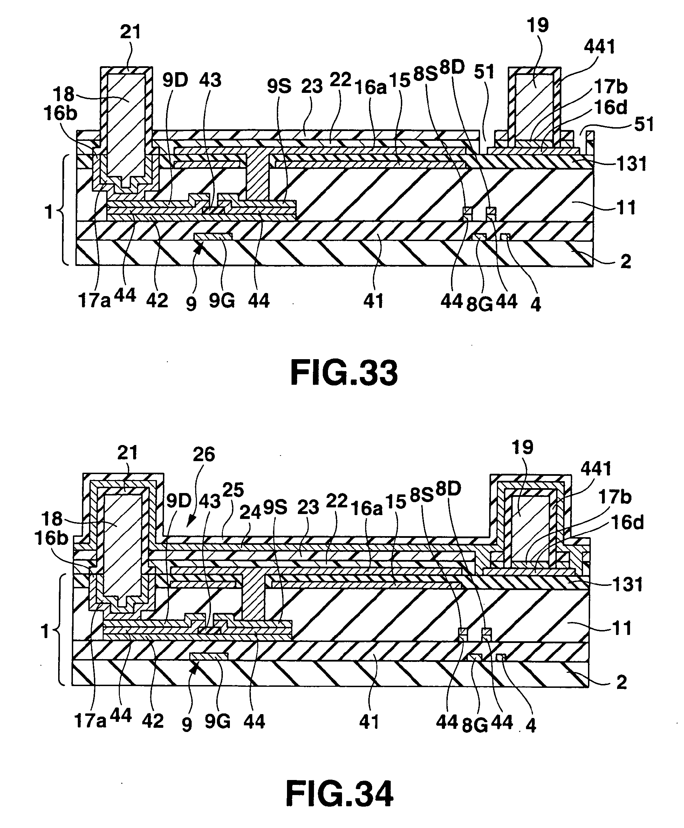

As shown in FIG. 33, a current source line insulating film 21 is formed to cover the current source line 18. An EL line insulating film 441 is formed in the same process as the current source line insulating film 21 to cover the EL line 19. With the above process, an organic EL driving substrate is completed.

A hole transport layer 22 made of polythiophene (PEDOT) and polystyrene sulfonate (PSS) as a dopant is formed by wet film formation such as droplet discharge (ink jet), spin coating, dip coating, or dropping by a needle. The hole transport layer 22 may be formed on the entire surface of the transistor array substrate 1 and shared by all pixels. Alternatively, the hole transport layer 22 may be formed independently for each pixel.

After the hole transport layer 22 is dried, a light-emitting layer 23 made of polyfluorene-based light-emitting material is patterned for each pixel by wet film formation such as droplet discharge (ink jet), dropping by a needle, or printing, as in the first embodiment. The hole transport layer 22 and light-emitting layer 23 are thinner than the EL line 19. The height of the solution or suspension as the prospective hole transport layer 22 and the height of the solution or suspension as the prospective light-emitting layer 23 which covers the pixel region are smaller than the height of the current source line 18 and the height of the EL line 19. Hence, the solution or suspension as the prospective hole transport layer 22 and the solution or suspension as the prospective light-emitting layer 23 do not flow to a pixel of an adjacent row over the current source line 18 and EL line 19. That is, the current source line 18 and EL line 19 function as partitions to prevent any outflow of the solution or suspension as the prospective hole transport layer 22 and the solution or suspension as the prospective light-emitting layer 23. Hence, when a plurality of pixels in the row direction surrounded along the current source line 18 and EL line 19 should have light-emitting layers which emit the same color light, the light-emitting layers 23 for the plurality of pixels in the row direction can be formed at once by supplying the solution or suspension for the light-emitting layer 23 between the current source line 18 and the EL line 19.

After the light-emitting layer 23 is dried, a contact hole 51 is formed in the hole transport layer 22 and light-emitting layer 23 to partially expose the surface of the auxiliary electrode line 16d.

As shown in FIG. 34, a common electrode 24 serving as a cathode electrode is formed on the entire surface by vapor deposition such as deposition. The common electrode 24 has a two-layer structure including an electron injection layer made of a low work function material such as magnesium, calcium, lithium, barium, or a rare-earth metal and a transparent conductive layer containing indium oxide, zinc oxide, tin oxide, or a mixture containing at least one of them (e.g., indium tin oxide (ITO), indium zinc oxide, or cadmium-tin oxide (CTO)). The electron injection layer having a thickness of 10 to 200 nm is so thin that visible light passes through it. Hence, the electron injection layer can be cut by the step of the current source line 18 or EL line 19. The transparent conductive layer of the common electrode 24 is formed across the current source line insulating film 21 on the current source line 18 and across the EL line insulating film 441 on the surface of the EL line 19 to set one electrode of each of organic EL elements 26 of the plurality of pixels at an equipotential. The common electrode 24 is connected to the auxiliary electrode line 16d and EL line 19 through the contact hole 51. The light-emitting layer 23 is covered with the common electrode 24 while being in tight contact with the common electrode 24. The EL line 19 is also covered with the common electrode 24 while being in tight contact with the common electrode 24 so that the organic EL element 26 is formed.

An overcoat insulating layer 25 is formed on the entire surface by spin coating, dip coating, or vapor deposition. A scan driver 32, data driver 33, and current source driver 34 are connected, and a transparent sealing substrate is bonded.

With the above process, an active matrix driving display device is completed.

Even in the fifth embodiment, the current source line 18 and EL line 19 are formed from a conductive film different from that forming part of the transistors 7, 8, and 9. For this reason, the current source line 18 and EL line 19 can be formed thicker than the drains, sources, and gates of the transistors 7, 8, and 9, a signal current line 3, and the scanning line 4.

### [Sixth Embodiment]

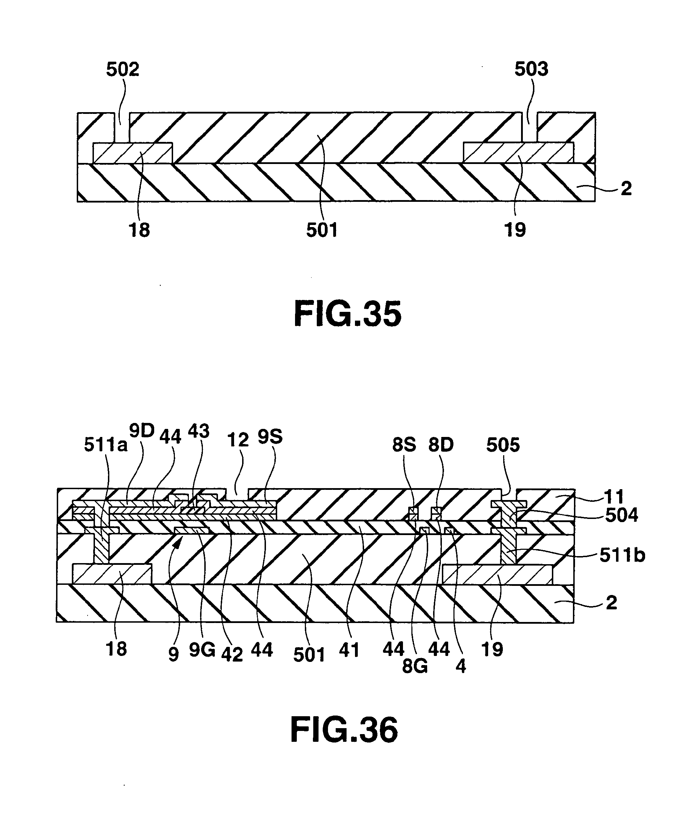

In the first embodiment, the current source line 18 and EL line 19 are formed on the transistor layer (multilayered film from the surface of the substrate 2 to the surface of the planarizing film 11). In the sixth embodiment, a current source line 18 and EL line 19 are formed under the transistor layer. More specifically, a manufacturing method shown in FIGS. 35 to 40 is employed.

A method of manufacturing an electroluminescent display panel according to the sixth embodiment will be described with reference to FIGS. 35 to 41. FIGS. 35 to 40 are sectional views of steps in the manufacturing method. The steps are executed in the order of FIGS. 35 to 40. The same reference numerals as in the electroluminescent display panel of the first embodiment denote the same parts in FIGS. 35 to 40, and some of the same steps as in the first embodiment are not illustrated.

As shown in FIG, 35, electroplating is executed to pattern a plurality of current source lines 18 and a plurality of EL lines 19 having a width of 5 to 50 µm and a thickness of 2 to 100 µm on a substrate 2. The current source lines 18 and EL lines 19 are patterned such that the current source lines 18 are provided in parallel to the EL lines 19, the current source lines 18 and EL lines 19 run up to the edge of the substrate 2, and the current source lines 18 and EL lines 19 run in the lateral direction of the substrate 2. Since the current source lines 18 and EL lines 19 are deposited thicker than the sources, drains, and gates of transistors 7, 8, and 9 (to be described later), the resistance per unit interconnection length is set lower than that of these electrodes.

An interlayer dielectric film 501 is formed on the entire surface of the substrate 2 to cover the current source line 18 and EL line 19. A contact hole 502 communicating with the current source line 18 and contact hole 503 communicating with the EL line 19 are formed in the interlayer dielectric film 501 in correspondence with each pixel.

As shown in FIG. 36, the three transistors 7, 8, and 9 are patterned for each pixel by appropriately executing a film forming process such as vapor deposition, a mask process such as photolithography, and a shaping process such as etching (the transistor 7 is not illustrated in FIG. 36). A conductive thin film serving as the prospective gates of the transistors 7, 8, and 9 is formed to bury a gate underlying film 511a in the contact hole 502 and a gate underlying film 511b in the contact hole 503. A contact hole to expose the gate underlying film 511a and a contact hole to expose the gate underlying film 511b are formed in a gate insulating film 41 at once. A conductive thin film serving as the prospective sources and drains of the transistors 7, 8, and 9 is patterned to bury a drain 9D of the current control transistor 9 and a source/drain underlying film 504 in the contact holes. Part of the conductive thin film as the prospective gates of the transistors 7, 8, and 9 is formed into a signal current line 3 by patterning.

Photolithography and etching are executed for a planarizing film 11 to form, in the planarizing film 11, a contact hole 12 communicating with a source 9S of each current control transistor 9 and a contact hole 505 communicating with the underlying film 504.

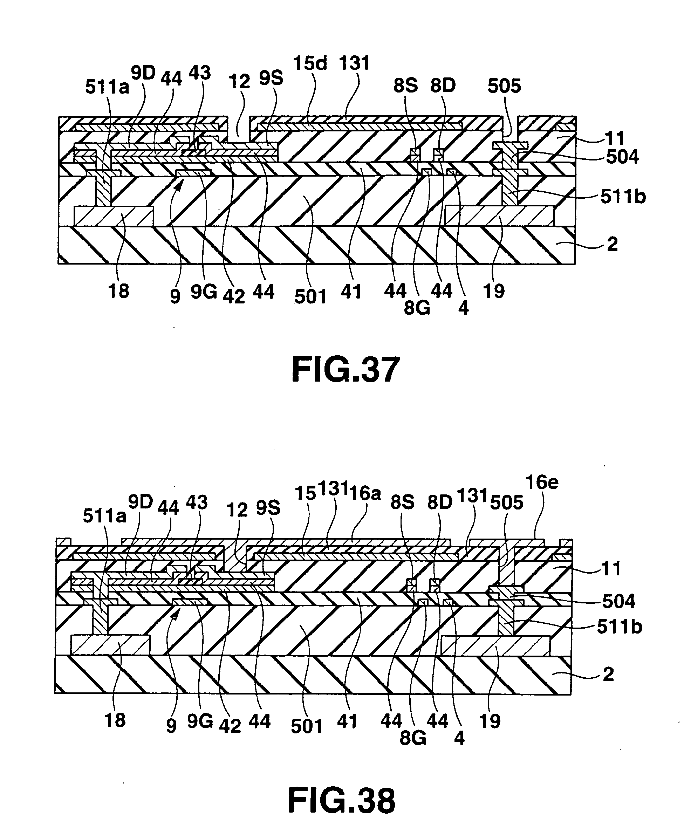

As shown in FIG. 37, a reflecting metal film 15d is patterned for each pixel by executing a film forming process such as vapor deposition, a mask process such as photolithography, and a shaping process such as etching in this order. A transparent insulating film 131 is formed on the entire surface by vapor deposition to cover the reflecting metal film 15d.

Contact holes are formed even in the transparent insulating film 131 in correspondence with the contact holes 12 and 505.

A transparent metal oxide film is formed on the entire surface of the transparent insulating film 131 by vapor deposition. The transparent metal oxide film is formed on the surface even in the contact holes 12 and 505 and contacts the source 9S of the current control transistor 9 and the underlying film 504.

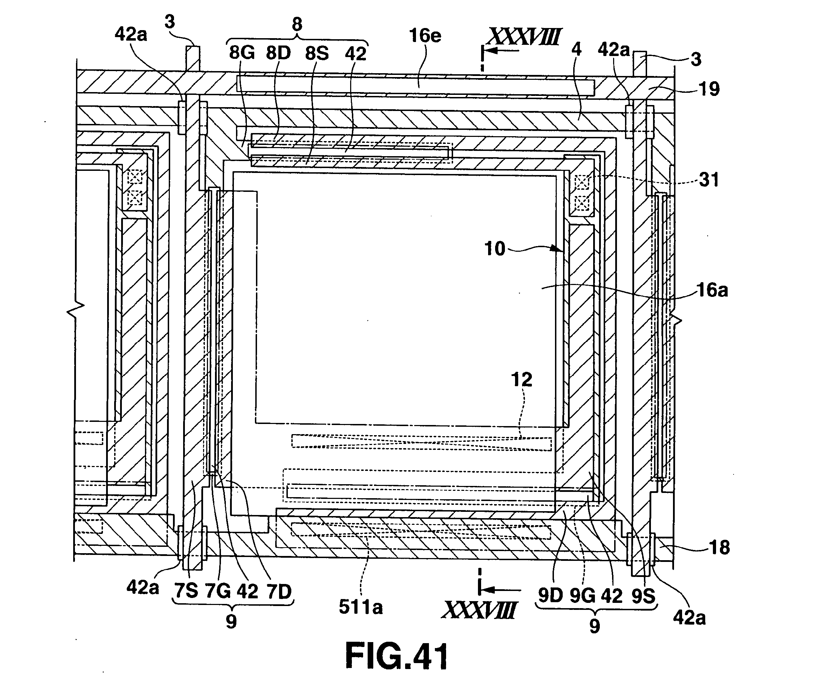

As shown in FIG. 38, photolithography and etching are executed for the transparent metal oxide film to form a pixel electrode 16a to be connected to the source 9S of the current control transistor 9 and an auxiliary electrode line 16e through the contact hole 505. FIG. 38 is a sectional view showing a section taken along a line XXXVIII - XXXVIII in FIG. 41 (to be described later) in the direction of the thickness.

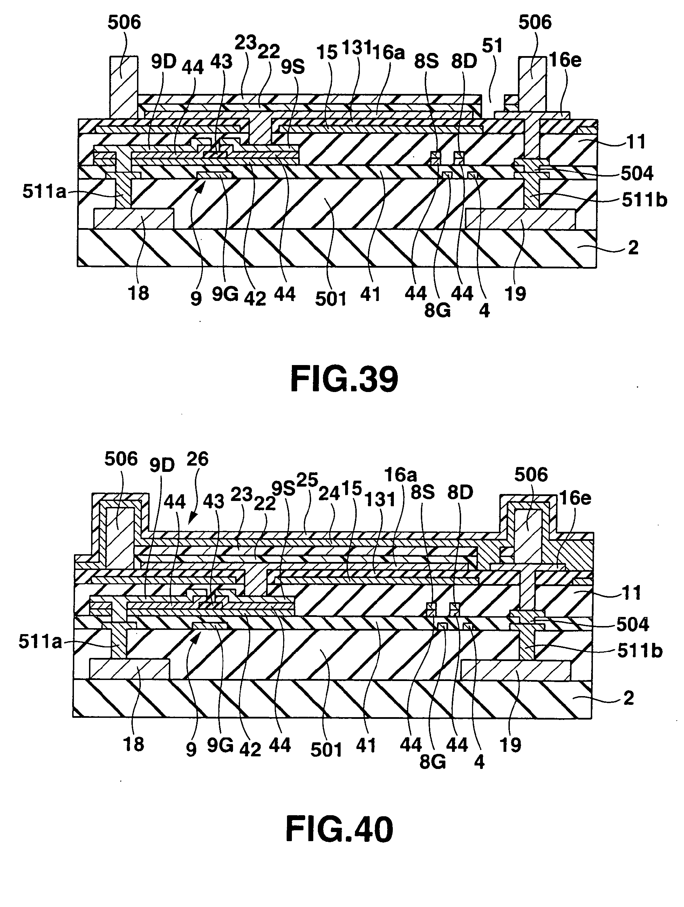

As shown in FIG. 39, a mesh-shaped partition 506 made of a photosensitive resin such as polyimide is patterned by photolithography. The partition 506 is patterned such that each pixel electrode 16a is surrounded by the mesh of the partition 506.

A hole transport layer 22 made of polythiophene (PEDOT) and polystyrene sulfonate (PSS) as a dopant is formed by wet film formation such as droplet discharge (ink jet), spin coating, dip coating, or dropping by a needle. The hole transport layer 22 may be formed on the entire surface of the transistor array substrate 1 and shared by all pixels. Alternatively, the hole transport layer 22 may be formed independently for each pixel.

After the hole transport layer 22 is dried, patterning is executed for each pixel by wet film formation, as in the first embodiment. The hole transport layer 22 and light-emitting layer 23 are thinner than a partition 231. The height of the solution or suspension as the prospective hole transport layer 22 and the height of the solution or suspension as the prospective light-emitting layer 23 which covers the pixel region are smaller than the height of the partitions 506. Hence, the solution or suspension as the prospective hole transport layer 22 and the solution or suspension as the prospective light-emitting layer 23 do not flow to a pixel of an adjacent row over the partitions 506. That is, the partitions 506 function as partitions to prevent any outflow of the solution or suspension as the prospective hole transport layer 22 and the solution or suspension as the prospective light-emitting layer 23. Hence, when a plurality of pixels in the row direction surrounded along the partitions 506 should have light-emitting layers which emit the same color light, the light-emitting layers 23 for the plurality of pixels in the row direction can be formed at once by supplying the solution or suspension for the light-emitting layer 23 between the partitions 506.

After the light-emitting layer 23 is dried, a contact hole 51 is formed in the hole transport layer 22 and light-emitting layer 23 to partially expose the surface of the auxiliary electrode line 16e.

As shown in FIG. 40, a common electrode 24 serving as a cathode electrode is formed on the entire surface by vapor deposition such as deposition. The common electrode 24 has a two-layer structure including an electron injection layer made of a low work function material such as magnesium, calcium, lithium, barium, or a rare-earth metal and a transparent conductive layer containing indium oxide, zinc oxide, tin oxide, or a mixture containing at least one of them (e.g., indium tin oxide (ITO), indium zinc oxide, or cadmium-tin oxide (CTO)). The electron injection layer having a thickness of 10 to 200 nm is so thin that visible light passes through it. Hence, the electron injection layer can be cut by the step of the partition 506. The transparent conductive layer of the common electrode 24 is formed across a current source line insulating film 21 on the surface of the partition 506 and across an EL line insulating film 441 on the surface of the partition 506 to set one electrode of each of organic EL elements 26 of the plurality of pixels at an equipotential. The common electrode 24 is connected to the auxiliary electrode line 16e through the contact hole 51. The light-emitting layer 23 is covered with the common electrode 24 while being in tight contact with the common electrode 24. The partition 506 is also covered with the common electrode 24 while being in tight contact with the common electrode 24 so that the organic EL element 26 is formed.

As shown in FIG. 40, an overcoat insulating layer 25 is formed on the entire surface by spin coating, dip coating, or vapor deposition. A scan driver 32, data driver 33, and current source driver 34 are connected, and a transparent sealing substrate is bonded.

With the above process, an active matrix driving display device is completed.

Even in the sixth embodiment, the current source line 18 and EL line 19 are formed in the process different from that of the transistors 7, 8, and 9 by patterning a conductive film different from the sources, drains, and gates of the transistors 7, 8, and 9. Since the current source line 18 and EL line 19 can be formed thicker than the drains, sources, and gates of the transistors 7, 8, and 9, a signal current line 3, and a scanning line 4, the electrical resistances of the current source line 18 and EL line 19 can be set low. Hence, the signal delay or voltage drop in the current source line 18 and EL line 19 can be suppressed.

### [Seventh Embodiment]

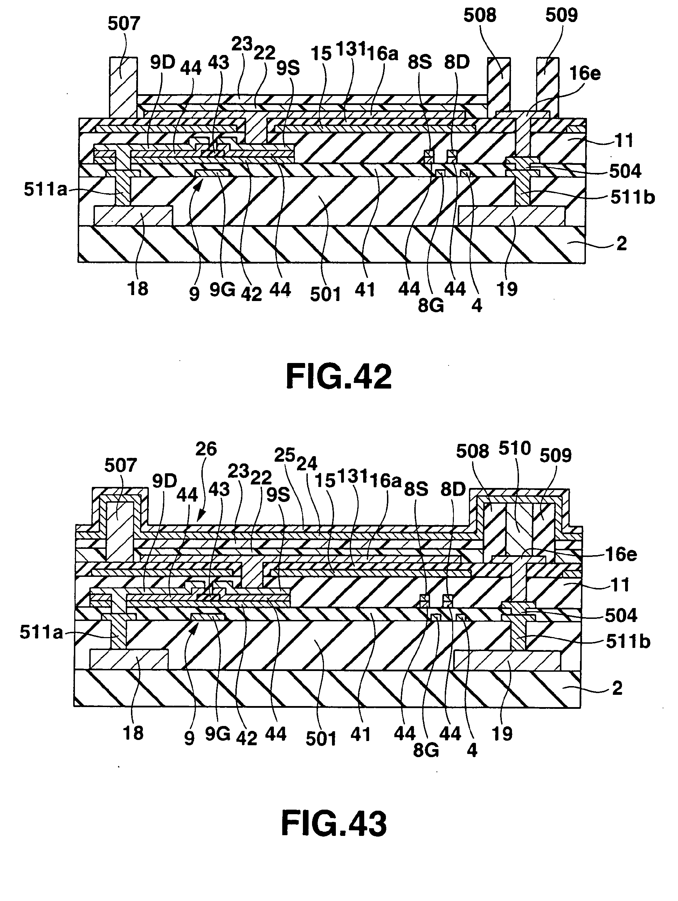

A method of manufacturing an electroluminescent display panel according to the seventh embodiment will be described with reference to FIGS. 42 and 43. FIGS. 42 and 43 are sectional views of steps in the manufacturing method. The steps are executed in the order of FIGS. 42 and 43. The same reference numerals as in the electroluminescent display panel of the sixth embodiment denote the same parts in FIGS. 42 and 43. The steps until the pixel electrode is formed in the seventh embodiment are the same as in FIGS. 35 to 38 of the sixth embodiment, and a description thereof will be omitted.

After a pixel electrode 16a is formed, a partition 507 is patterned along a current source line 18 by photolithography, as shown in FIG. 42. Partitions 508 and 509 are formed along an EL line 19 in the same process as the partition 507. The partitions 507 and 508 are formed such that the pixel electrode 16a is located between them. The partitions 508 and 509 are formed such that an auxiliary electrode line 16e remaining on an underlying film 504 is located between them when viewed from the upper side.

A conductive paste 510 is buried between the partitions 508 and 509. The conductive paste 510 is in tight contact with the auxiliary electrode line 16e remaining on the underlying film 504.

After the conductive paste 510 is dried, a hole transport layer 22 and light-emitting layer 23 are formed, as in the sixth embodiment. At this time, the partitions 507 and 508 have the same function as that of the partition 506 of the sixth embodiment.

As shown in FIG. 43, a common electrode 24 is formed on the entire surface, as in the sixth embodiment. The light-emitting layer 23 is covered with the common electrode 24 while being in tight contact with the common electrode 24. The conductive paste 510 is also in tight contact with the common electrode 24. Hence, the common electrode 24 is connected to the EL line 19 through the conductive paste 510, auxiliary electrode line 16e, source/drain underlying film 504, and a gate underlying film 511b.

An overcoat insulating layer 25 is formed on the entire surface by spin coating, dip coating, or vapor deposition. A scan driver 32, data driver 33, and current source driver 34 are connected, and a transparent sealing substrate is bonded.

With the above process, an active matrix driving display device is completed.

Even in the seventh embodiment, the current source line 18 and EL line 19 are formed in the process different from that of transistors 7, 8, and 9. Since the current source line 18 and EL line 19 can be formed thicker than the drains, sources, and gates of the transistors 7, 8, and 9, a signal current line 3, and a scanning line 4, the resistances of the current source line 18 and EL line 19 can be set lower than that of the transistors 7, 8, and 9. The electrical resistances of the current source line 18 and EL line 19 can be set low. Hence, the signal delay or voltage drop in the current source line 18 and EL line 19 can be suppressed.

In the above embodiments, light emitted from the light-emitting layer 23 is caused to exit from the side of the common electrode 24 by providing the reflecting metal film 15. However, the present invention is not limited to this. Light emitted from the light-emitting layer 23 may be caused to exit from the side of the pixel electrode 16a without providing the reflecting metal film 15. In this case, the common electrode 24 is preferably opaque or reflects light. Especially, the common electrode 24 preferably has a multilayered structure including an electron emission film with a low work function and a conductive film which has a high work function and protects the electron emission film by covering it.

### [Eighth Embodiment]

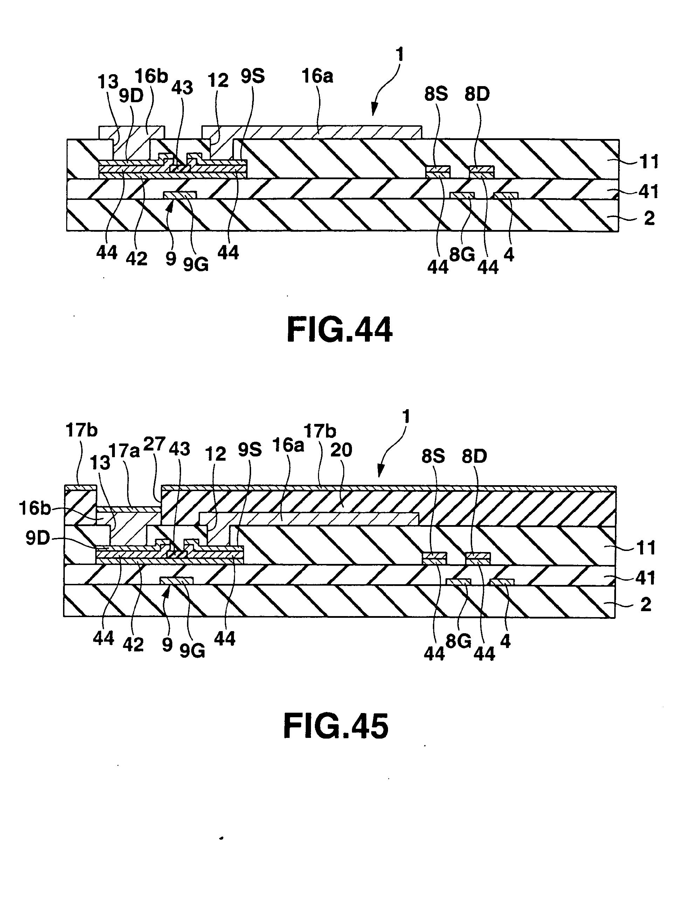

A method of manufacturing a display device which has organic electroluminescent elements serving as light-emitting elements as pixels will be described with reference to FIGS. 44 to 50. FIGS. 44 to 50 are sectional views of steps in the manufacturing method. The steps are executed in the order of FIGS. 44 to 50. The same reference numerals as in the electroluminescent display panel of the first embodiment denote the same parts in FIGS. 44 to 50, and some of the same steps as in the first embodiment are not illustrated.

FIGS. 44 to 50 are sectional views of one pixel obtained by cutting a current control transistor 9 along a plane perpendicular to a scanning line 4. The remaining pixels also take the states shown in FIGS. 44 to 50 in the respective steps.

As shown in FIG. 44, photolithography and etching are executed for a prepared transistor array substrate 1 to form, in an insulating film 11, a contact hole 12 communicating with a source 9S of each current control transistor 9 and a contact hole 13 communicating with a drain 9D of each current control transistor 9.

A conductive film made of a conductive material selected from a simple metal such as aluminum, titanium, or gold, an alloy thereof, or a transparent metal oxide film is formed on the entire surface of the transistor array substrate 1 by vapor deposition such as sputtering or deposition. The conductive film is formed on the surface even in the contact holes 12 and 13. A transparent metal oxide film selected from indium oxide, zinc oxide, tin oxide, and a mixture containing at least one of them (e.g., indium tin oxide (ITO), indium zinc oxide, or cadmium-tin oxide (CTO)) is formed on the conductive film.

The stacked conductive films are patterned to form a pixel electrode 16a connected to the source 9S of the current control transistor 9 and an underlying interconnection 16b arranged in the row direction and connected to the drain 9D of the current control transistor 9 arrayed along the row direction.

As shown in FIG. 45, an interlayer dielectric film 20 made of a liquid-repellent insulating film, or silicon nitride or silicon oxide is formed. A contact hole 27 is formed in the interlayer dielectric film 20 at a position corresponding to the drain 9D of the current control transistor 9 to expose the drain 9D. After that, an underlayer made of a metal material such as copper or nickel is formed on the entire surface by sputtering or deposition. The underlayer is separated by the step of the interlayer dielectric film 20 into an underlayer 17a formed on the drain 9D in the contact hole 27 and an underlayer 17b on the interlayer dielectric film 20. The underlayers 17a and 17b are electrically insulated from each other and run in row direction. A photoresist film 61 exposes the metal layer 17 connected to interconnections 36 through contact holes 37, the metal layer 17 connected to interconnections 39 through contact holes 40, and the metal layer 17 connected to interconnections 45 through contact holes 46.

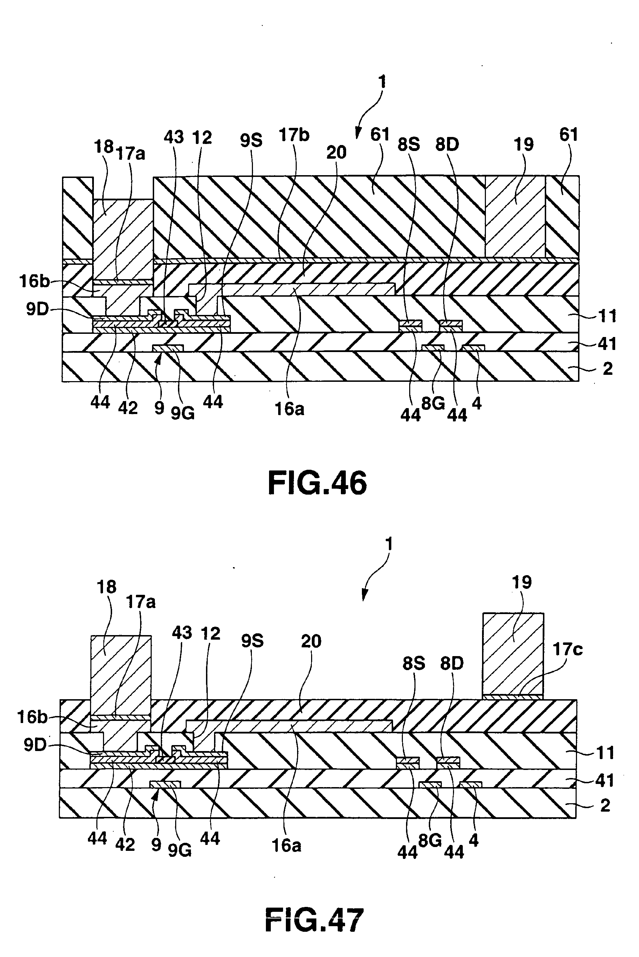

As shown in FIG. 46, the photoresist film 61 is formed to expose the underlayer 17a on the drain 9D and the underlayer 17b on the interlayer dielectric film 20 at a position along the row direction on the side of one of the plurality of peripheral sides of the pixel electrode 16a, which opposes the peripheral side on the underlayer 17a side on the drain 9D. When electroplating is executed by using the exposed underlayers 17a and 17b as electrodes, a current source line 18 formed from a thick copper plating film having a thickness of 2 to 100 µm and a width of 5 to 50 µm is formed on the underlayer 17a on the drain 9D. In addition, an EL line 19 formed from a thick copper plating film having a thickness of 2 to 100 µm and a width of 5 to 50 µm is formed on the underlayer 17b on the interlayer dielectric film 20 at the position along the row direction on the side of one of the plurality of peripheral sides of the pixel electrode 16a, which opposes the peripheral side on the underlayer 17a side on the drain 9D. Furthermore, a common interconnection 35 which connects the EL lines 19 to each other on the left side of the display region and a common interconnection 38 which connects the EL lines 19 to each other on the right side of the display region are formed.

As shown in FIG. 47, after the photoresist film 61 is removed, the exposed underlayer 17b is etched except the portions covered with the current source line 18 and EL line 19 to form an underlayer 17c under EL line 19.

FIG. 8 is a plan view of the pixel at this time. FIG. 47 is a sectional view showing a section taken along a line V - V in FIG. 8 in the direction of the thickness. As shown in FIG. 8, the current source line 18 and EL line 19 are provided in parallel to the scanning line 4. The current source line 18 partially overlaps the underlayers 17a provided in the contact holes 13 of all pixels arrayed in the lateral direction (row direction), i.e., the pixels of each row when viewed from the upper side. Hence, the drains 9D of the current control transistors 9 of all pixels of each row are electrically connected to the current source line 18 of the row.

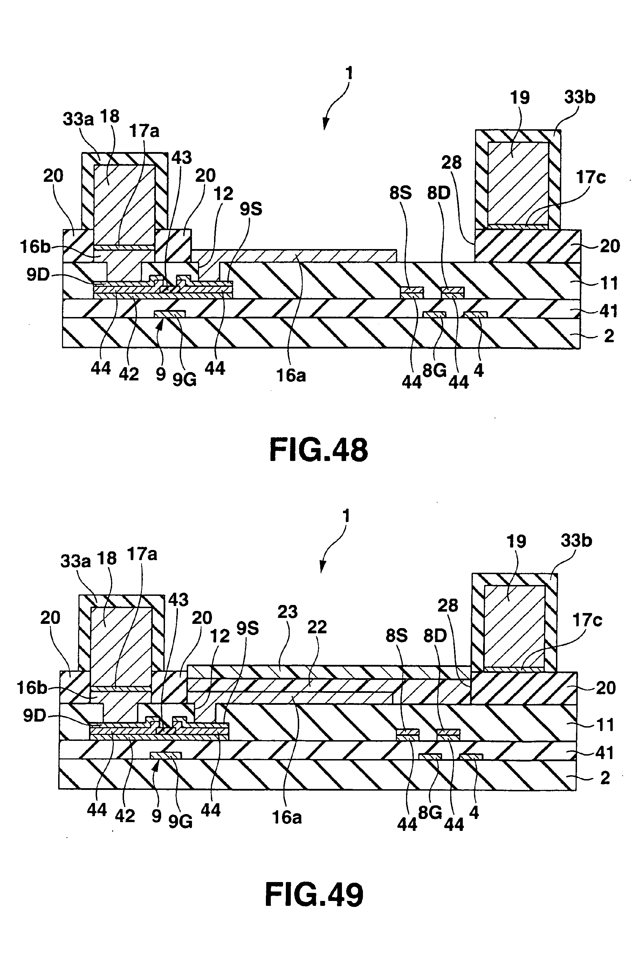

As shown in FIG. 48, liquid-repellent insulating films 33a and 33b are formed by electrodeposition coating by applying a voltage to the current source lines 18 and EL lines 19 to selectively cover only the surfaces of the current source lines 18, EL lines 19, and common interconnections 35 and 38. The liquid-repellent insulating films 33a and 33b are sufficiently thick and are therefore not electrically connected to the current source line 18 and EL line 19 even when a conductor is formed on the surfaces of the liquid-repellent insulating films 33a and 33b. The liquid-repellent insulating films 33a and 33b can be formed by patterning a liquid-repellent photosensitive resin by photolithography.

As shown in FIG. 49, a hole transport layer 22 made of polythiophene (PEDOT) and polystyrene sulfonate (PSS) as a dopant is formed by wet film formation such as droplet discharge (ink jet), spin coating, dip coating, or dropping by a needle. The hole transport layer 22 may be formed on the entire surface of the transistor array substrate 1 and shared by all pixels. Alternatively, the hole transport layer 22 may be formed independently for each pixel. The liquid-repellent insulating films 33a and 33b repel the hole transport layer material containing solution. Since the film of the hole transport layer material containing solution is not formed nonuniformly along the current source line 18 and EL line 19, the film can be formed with a uniform thickness on the pixel electrode 16a. FIG. 49 shows a state in which after the region surrounded by the current source line 18 and EL line 19 is filled with a solution or suspension containing the material of the hole transport layer 22, the solvent or water volatilizes to form the hole transport layer 22.

After the hole transport layer 22 is dried, a light-emitting layer 23 is formed by wet film formation such as droplet discharge (ink jet), spin coating, dip coating, or injection by a needle by using a solution containing a polyparavinylene-based light-emitting or polyfluorene-based light-emitting material having conjugated double bonds. As shown in FIG. 9, the light-emitting layer 23 is formed continuously for a plurality of pixels along the current source line 18 and EL line 19. Red light-emitting layers 23R to emit red light, green light-emitting layers 23G to emit green light, and blue light-emitting layers 23B to emit blue light are formed for the respective rows. The reflecting metal underlying film 15c, transparent metal oxide underlying film 16c, underlayer 17b, and EL line 19 remain on the organic EL isolation insulating film 14. The hole transport layer 22 and light-emitting layer 23 are thinner than the organic EL isolation insulating film 14. The height of the solution or suspension as the prospective hole transport layer 22 and the height of the solution or suspension as the prospective light-emitting layer 23 which covers the pixel region are smaller than the height of the current source line 18 and the height of the EL line 19. Hence, the solution or suspension as the prospective hole transport layer 22 and the solution or suspension as the prospective light-emitting layer 23 do not flow to a pixel of an adjacent row over the current source line 18 and EL line 19. That is, the current source line 18 and EL line 19 function as partitions to prevent any outflow of the solution or suspension as the prospective hole transport layer 22 and the solution or suspension as the prospective light-emitting layer 23. Hence, as shown in FIG. 9, when a plurality of pixels in the row direction surrounded along the current source line 18 and EL line 19 should have light-emitting layers which emit the same color light, the light-emitting layers 23 for the plurality of pixels in the row direction can be formed at once by supplying the solution or suspension for the light-emitting layer 23 between the current source line 18 and the EL line 19.

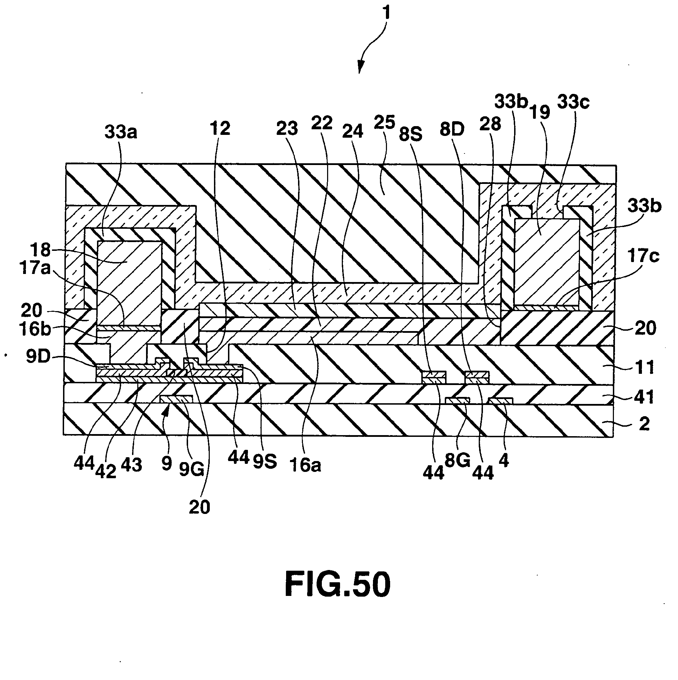

As shown in FIG. 50, a contact hole 33c is formed in the liquid-repellent insulating film 33b to expose the EL line 19 in the running direction. The contact hole 33c may be formed by eliminating a part of the liquid-repellent insulating film 33b by laser scanning.

A common electrode 24 serving as a cathode electrode is formed on the entire surface by vapor deposition such as deposition. The common electrode 24 has a two-layer structure including an electron injection layer made of a low work function material such as magnesium, calcium, lithium, barium, or a rare-earth metal and a transparent conductive layer containing indium oxide, zinc oxide, tin oxide, or a mixture containing at least one of them (e.g., indium tin oxide (ITO), indium zinc oxide, or cadmium-tin oxide (CTO)). The electron injection layer having a thickness of 1 to 20 nm is so thin that visible light passes through it. Hence, the electron injection layer can be cut by the step of the current source line 18 or EL line 19. The transparent conductive layer of the common electrode 24 is formed across the liquid-repellent insulating film 33a on the current source line 18 and across the EL line 19 to set one electrode of each of organic EL elements 26 of the plurality of pixels at an equipotential. The light-emitting layer 23 is covered with the common electrode 24 while being in tight contact with the common electrode 24. The EL line 19 is also covered with the common electrode 24 while being in tight contact with the common electrode 24. The common electrode 24 is electrically connected to the EL line 19 through the contact hole 33c but insulated from the current source line 18 by the liquid-repellent insulating film 33a.

An overcoat insulating layer 25 is formed on the entire surface by spin coating, dip coating, or vapor deposition. A scan driver 32, data driver 33, and current source driver 34 are connected, and a transparent sealing substrate is bonded.

### [Ninth Embodiment]

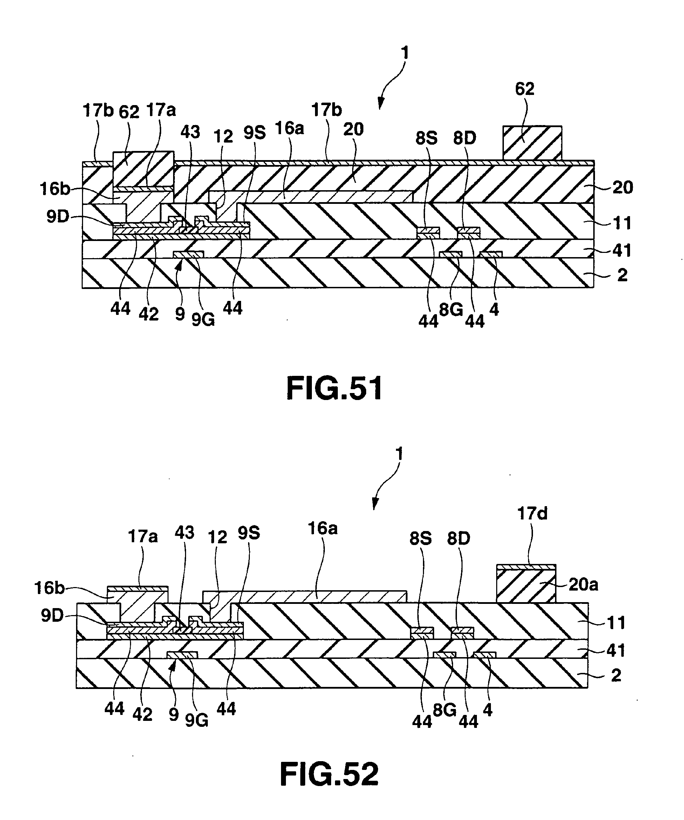

A method of manufacturing an electroluminescent display panel according to the ninth embodiment will be described with reference to FIGS. 51 to 56. FIGS. 51 to 56 are sectional views of steps in the manufacturing method. The steps are executed in the order of FIGS. 51 to 56. The same reference numerals as in the electroluminescent display panel of the eighth embodiment denote the same parts in FIGS. 51 to 56.

In this embodiment, after a transistor array substrate 1 is manufactured, underlayers 17a and 17b are formed by the processes shown in FIGS. 44 and 45, as in the eighth embodiment. As shown in FIG. 51, a photoresist film 62 is patterned on the underlayer 17a and on an interlayer dielectric film 20 at a position along the row direction on the side of one of the plurality of peripheral sides of a pixel electrode 16a, which opposes the peripheral side on the underlayer 17a side.

As shown in FIG. 52, by using the photoresist film 62 as a mask, the underlayer 17a is protected, and the exposed underlayer 17b is etched to form an underlayer 17d. The interlayer dielectric film 20 except the portion under the underlayer 17d is removed by etching, thereby patterning an interlayer dielectric film 20a and exposing the pixel electrode 16a. The photoresist film 62 is removed to expose the underlayers 17a and 17d.

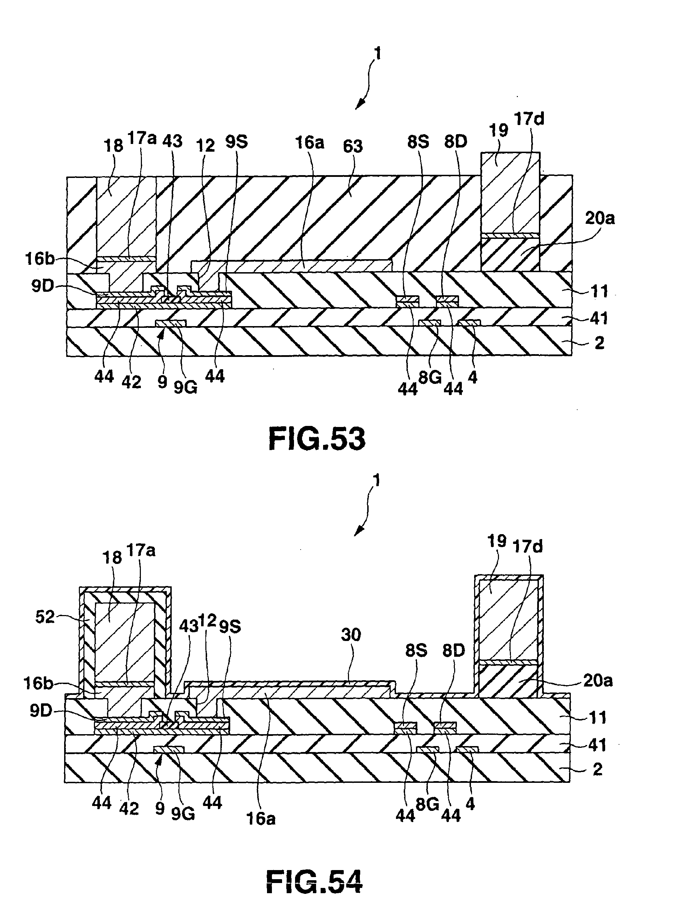

As shown in FIG. 53, a photoresist film 63 is formed while exposing the underlayers 17a and 17d. As in the eighth embodiment, electroplating is executed. A current source line 18 formed from a thick copper plating film having a thickness of 2 to 100 µm, i.e., thicker than the sources, drains, and gates of transistors 7, 8, and 9, and a width of 5 to 50 µm is selectively formed on the underlayer 17a. In addition, an EL line 19 formed from a thick copper plating film having a thickness of 2 to 100 µm and a width of 5 to 50 µm is selectively formed on the underlayer 17d.

After the photoresist film 63 is removed, an insulating film 52 which covers at least the exposed surface of the current source line 18, the side surface of the underlayer 17a, and the side surface of an underlying interconnection 16b is formed, as shown in FIG. 54. At this time, the insulating film 52 to cover the side surface of the current source line 18 is preferably formed to a thickness not to lose its insulating properties because of the height of the current source line 18. After that, a wettability changeable conductive film 30 is formed on the entire surface. Since the surface of the pixel electrode 16a is flat, the wettability changeable conductive film 30 becomes a flat thin film in the region overlapping the pixel electrode 16a. The wettability changeable conductive film 30 is also formed on the side surfaces of the insulating film 52, EL line 19, and interlayer dielectric film 20. The wettability changeable conductive film 30 has low wettability and high liquid repellency. The wettability changeable conductive film 30 is very thin and is therefore rendered conductive in the direction of the thickness.

The method of forming the wettability changeable conductive film 30 will be described in detail.

A solution (to be referred to as a silazane-based solution hereinafter) containing a silazane compound having a functional group containing fluorine is applied to the surface of the transistor array substrate 1 on which the pixel electrode 16a is formed, thereby forming a film of the silazane compound solution.

The "silazane compound having a functional group containing fluorine" has Si-N-Si bonds. The functional group containing fluorine is bonded to N and/or Si. Examples are oligomers or polymers expressed by

RfSi(NH)_{3/2} (1)

where Rf is a functional group containing fluorine.

An example of the "functional group containing fluorine" is a fluoroalkyl group. Examples of the functional group are
- (CH₂)ₐ(CF₂)_{b}CF₃ (2)
- (CH₂)ₐ(CF₂)_{b}CF(CF₃)₂ (3)
- (CH₂)ₐ(CF₂)_{b}C(CF₃)₃ (4)
- (CF₂)ₐCF₃ (5)
- (CF₂)ₐCF(CF₃)₂ (6)
- (CF₂)ₐC(CF₃)₃ (7)
- (CF₂)ₐ(C(CF₃)₂)_{b}CF₃ (8)
- (CF₂)ₐ(C(CF₃)₂)_{b}CF(CF₃)₂ (9)
- (CF₂)ₐ(C(CF₃)₂)_{b}C(CF₃)₃ (10)
- (CF₂)ₐ(C(CF₃)₂)_{b}(CF₂)_{c}CF₃ (11)
- (CF₂)ₐ(C(CF₃)₂)_{b}(CF₂)_{c}CF(CF₃)₂ (12)
- (CF₂)ₐ(C(CF₃)₂)_{b}(CF₂)_{c}C(CF₃)₃ (13)
- (C(CF₃)₂)ₐCF₃ (14)
- (C(CF₃)₂)ₐCF(CF₃)₂ (15)
- (C(CF₃)₂)ₐC(CF₃)₃ (16)
- (C(CF₃)₂)ₐ(CF₂)_{b}CF₃ (17)
- (C(CF₃)₂)ₐ(CF₂)_{b}CF(CF₃)₂ (18)
- (C(CF₃)₂)ₐ(CF₂)_{b}C(CF₃)₃ (19)
where a, b, and c are integers.

An example of the solvent medium of the silazane-based solution is a fluorine-based solvent.

In this example, silazane oligomer (KP-801M: available Shin-Etsu Chemical) expressed by

C₈F₁₇C₂H₄Si(NH)_{3/2} (20)

is used. In the above-described dip coating process, the transistor array substrate 1 is immersed in a silazane-based solution (concentration: 3 wt%) which is prepared by dissolving the silazane oligomer as a solute in an m-xylenehexafluoride solvent medium.

When an inert gas such as nitrogen gas is blown to the transistor array substrate 1 to evaporate the solvent medium of the silazane-based solution, the silazane compound is deposited on the surfaces of the pixel electrode 16a and interlayer dielectric film 20.

When the transistor array substrate 1 is let stand for 10 to 30 min, the silazane compound is hydrolyzed and condensed by water in the atmosphere. With this process, as shown in FIG. 54, the wettability changeable conductive film 30 made of the condensate bonded to the functional group containing fluorine is formed on the entire surface to cover all the pixel electrodes 16a and substrate.

The silazane compound is condensed in the planar direction of the surface of the pixel electrode 16a. In addition, the main chain in the monomolecular unit, i.e., the Rf-Si-X group or Rf-Si group is rarely stacked on the main chain in the monomolecular unit, i.e., the Rf-Si-X group or Rf-Si group formed on the surface of the pixel electrode 16a. X is the atom or atom group of the pixel electrode 16a, which is bonded to the silazane compound. For this reason, the thickness of the wettability changeable conductive film 30 almost equals the length of the main chain in the monomolecular unit (corresponding to the side chain of the condensate), i.e., the Rf-Si-X group or Rf-Si group. In addition, the wettability changeable conductive film 30 is condensed such that the functional group Rf containing fluorine in the main chain in the monomolecular unit is arranged on the surface side of the wettability changeable conductive film 30. Hence, the surface of the wettability changeable conductive film 30 exhibits liquid repellency against an organic compound containing solution because of the liquid repellency of the functional group Rf.

When the wettability changeable conductive film 30 is formed in the above-described way, the wettability changeable conductive film 30 is rinsed by an m-xylenehexafluoride solution (same solution as the solvent medium of the silazane-based solution) to wash away the deposited unreacted silazane compound or extra silazane compound.

A photomask substrate is made to oppose the transistor array substrate 1. Active rays are caused to pass through the photomask substrate to partially irradiate the wettability changeable conductive film 30 with the active rays. The wettability changeable conductive film 30 is patterned to form parts with low wettability and parts with high wettability. Examples of the active rays are visible light, UV rays, and infrared rays to excite a photocatalytic film (to be described later).

The photomask substrate will be described. The photomask substrate has a transparent substrate to pass active rays. A mask which is formed into a mesh shape having a plurality of opening portions arrayed in a matrix corresponding to the plurality of pixel electrodes 16a is formed on one surface of the transparent substrate. A photocatalytic film having a thickness of about 0.2 µm is formed on the entire surface to cover the whole mask. Each opening portion is set to a width to form an opening between the current source line 18 and the EL line 19 along the row direction.

The mask does not reflect, absorb, or pass the active rays. The photocatalytic film is made of one or two or more substances selected from titanium oxide (TiO₂), zinc oxide (ZnO), tin oxide (SnO₂), strontium titanate (SrTiO₃), tungsten oxide (WO₃), bismuth oxide (Bi₂O₃), and iron oxide (Fe₂O₃).

The active rays are applied to the photomask substrate. The active rays are blocked by the mask but pass through the photocatalytic film at opening portions without the mask. The active rays do not enter the region of the wettability changeable conductive film 30 overlapping the mask, i.e., the periphery of the pixel electrode 16a but enter the region overlapping the pixel electrode 16a.

When the active rays pass through the photocatalytic film, an active oxygen species (·OH) is generated. The active oxygen species causes chemical reaction with the wettability changeable conductive film 30. The active oxygen species which has passed through the photocatalytic film reaches the region of the wettability changeable conductive film 30 overlapping the pixel electrode 16a. The active oxygen species does not reach the region overlapping the mask because the mask blocks the active rays. With the function of the photocatalyst, the active oxygen species is generated when the active rays enter the photocatalytic film. The generated active oxygen species reaches the wettability changeable conductive film 30 and changes its chemical structure.

In the region of the wettability changeable conductive film 30 overlapping the opening portion, the Rf group having liquid repellency substitutes for a hydroxyl group having an affinity for water due to the active oxygen species (·OH) generated by the function of the photocatalyst so that a lyophilic film 30a is formed. Since the functional group (Rf) containing fluorine is decomposed and eliminated and substitutes for the hydroxyl group, the lyophilic film 30a is lyophilic to an organic compound containing solution. For this reason, a liquid containing the material of an electroluminescent layer 23 (to be described later) is not repelled, and a film of the liquid can uniformly be formed on the surface of the lyophilic film 30a.

In the lyophilic film 30a, the main chain in the condensate containing silicon and oxygen is formed along the surface of the pixel electrode 16a. In addition, the functional group containing fluorine and having liquid repellency substitutes for the hydroxyl group. Since the thickness equals the length of the main chain in the monomolecular unit (corresponding to the side chain of the condensate), i.e., the HO-Si-X group or HO-Si group, a very thin lyophilic film having a thickness of 1 nm or less can be formed. On the pixel electrode 16a in the region where the active oxygen species is generated, the pattern film or wettability changeable conductive film 30 is very thin. Hence, the lyophilic film 30a itself rarely inhibit injection or transport of charges such as holes.

The active oxygen species does not reach the region of the wettability changeable conductive film 30 overlapping the mask, and no chemical reaction occurs. This region still exhibit liquid repellency against the liquid containing the material of the light-emitting layer (to be described later). A liquid-repellent film 30b having the same characteristic as the wettability changeable conductive film 30 is formed in this region. The liquid-repellent film 30b is formed continuously from the lyophilic film 30a and is thicker than the lyophilic film 30a by an amount almost corresponding to the functional group Rf containing fluorine.

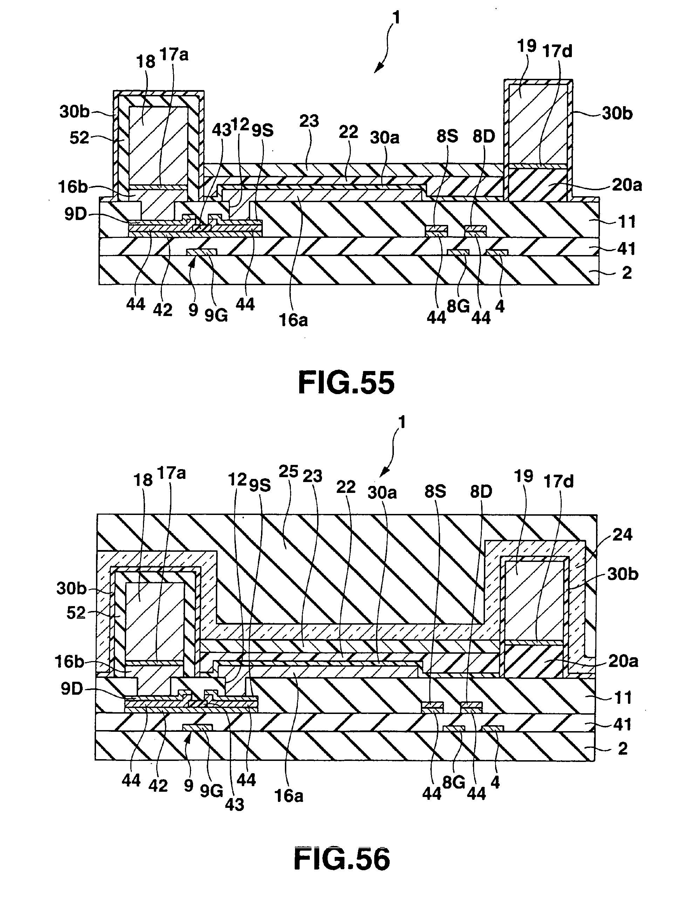

An EL layer is formed on each pixel, i.e., each lyophilic film 30a. This will be described with reference to FIG. 55 by exemplifying a hole transport layer 22 and light-emitting layer 23 as EL layers.

A film of an aqueous solution or suspension containing polythiophene and polystyrene sulfonate as a dopant is formed by wet film formation such as spin coating or dip coating. The aqueous solution or suspension readily wets and smears the lyophilic film 30a having lyophilic properties. The aqueous solution or suspension hardly wets the liquid-repellent film 30b having liquid repellency and is readily repelled. For these reasons, the aqueous solution or suspension is selectively applied to the lyophilic film 30a. When the solvent medium of the aqueous solution or suspension dries on the lyophilic film 30a, the hole transport layer 22 is formed. The aqueous solution or suspension containing the material of the hole transport layer 22 is deposited thicker than the light-emitting layer 23 at the early stage of film formation because it contains several vol% of the material of the hole transport layer 22. However, since the current source line 18 and EL line 19 serve as partitions much higher than the solution or suspension, the aqueous solution or suspension can be prevented from flowing to a row adjacent to the row so that a film having a uniform thickness can be formed.

The current source line 18 can partition the hole transport layer 22 as at least one side of the block
where the hole transport layer 22 is formed. The EL line 19 can partition the hole transport layer 22 as at least another side of the block where the hole transport layer 22 is formed.

After the hole transport layer 22 is formed, as shown in FIG. 55, the light-emitting layer 23 made of a polyfluorene-based light-emitting material is formed for each pixel by wet film formation such as printing, like the hole transport layer 22. The aqueous solution or suspension containing the material of the light-emitting layer 23 is deposited thicker than the light-emitting layer 23 at the early stage of film formation because it contains several vol% of the material of the light-emitting layer 23. However, since the current source line 18 and EL line 19 serve as partitions much higher than the solution or suspension, the aqueous solution or suspension can be prevented from flowing to a row adjacent to the row.

Hence, when a plurality of pixels in the row direction surrounded along the current source line 18 and EL line 19 should have light-emitting layers which emit the same color light, the light-emitting layers 23 for the plurality of pixels in the row direction can be formed at once by supplying the solution or suspension containing the material of the light-emitting layer 23 between the current source line 18 and the EL line 19.

The current source line 18 can partition the light-emitting layer 23 as at least one side of the block where the light-emitting layer 23 is formed. The EL line 19 can partition the light-emitting layer 23 as at least another side of the block where the light-emitting layer 23 is formed.

As shown in FIG. 56, a common electrode 24 made of a transparent electrode is formed on the entire surface. The upper surface is sealed by an overcoat insulating layer 25. The common electrode 24 is formed on the insulating film 52 and therefore electrically insulated from the current source line 18. Although the liquid-repellent film 30b is inserted between the common electrode 24 and the EL line 19, they are electrically connected because the liquid-repellent film 30b is very thin and has no sufficient insulating properties. Hence, all the EL lines 19 are connected to each other through the common electrode 24. The common electrode 24 is a transparent electrode made of ITO or the like and therefore has a high resistivity. However, since the EL line 19 is deposited thicker than sources 7S, 8S, and 9S, drains 7D, 8D, and 9D, and gates 7G, 8G, and 9G of the transistors 7, 8, and 9 such that the resistance per unit length becomes lower than these electrodes, a sufficient current can be supplied from the cathodes of organic EL elements 26 of all pixels. In addition, since the current source line 18 is deposited thicker than the sources 7S, 8S, and 9S, drains 7D, 8D, and 9D, and gates 7G, 8G, and 9G of the transistors 7, 8, and 9 such that the resistance per unit length becomes lower than these electrodes, a sufficient current can be supplied to the anodes of the organic EL elements 26 of the pixels of each row.

The overcoat insulating layer 25 is formed on the entire surface by spin coating, dip coating, or vapor deposition. A scan driver 32, data driver 33, and current source driver 34 are connected, and a transparent sealing substrate is bonded.

Each pixel of the completed display device has the structure shown in FIG. 10. The current control transistor 9 and organic EL element 26 are connected in series between the current source line 18 and the EL line 19. More specifically, the drain 9D of the current control transistor 9 is connected to the current source line 18. The source 9S of the current control transistor 9 is connected to the pixel electrode 16a serving as the anode of the organic EL element 26. The common electrode 24 serving as the cathode of the organic EL element 26 is connected to the EL line 19.

Since the current source line 18 does not overlap the pixel electrode 16a when viewed from the upper side, the parasitic capacitance to the pixel electrode 16a can be suppressed. To suppress the parasitic capacitance to a scanning line 4 and the signal delay in the scanning line 4, the current source line 18 preferably does not overlap the scanning line 4 when viewed from the upper side. When the overlap area between the current source line 18 and a signal current line 3 to which a microcurrent flows is small when viewed from the upper side, the parasitic capacitance to the signal current line 3 can be suppressed. The current source line 18 may be made narrow at the portion overlapping the signal current line 3, as shown in FIG. 8.

Since the EL line 19 does not overlap the pixel electrode 16a when viewed from the upper side, the parasitic capacitance to the pixel electrode 16a can be suppressed. To suppress the parasitic capacitance to the scanning line 4 and the signal delay in the scanning line 4, the EL line 19 preferably does not overlap the scanning line 4 when viewed from the upper side. When the overlap area between the EL line 19 and the signal current line 3 to which a microcurrent flows is small when viewed from the upper side, the parasitic capacitance to the signal current line 3 can be suppressed. The EL line 19 may be made narrow at the portion overlapping the signal current line 3.

In this embodiment, the current source line 18 and EL line 19 are formed from a conductive film different from that forming the transistors 7, 8, and 9. For this reason, the current source line 18 and EL line 19 can be deposited thicker than the sources 7S, 8S, and 9S and drains 7D, 8D, and 9D of the transistors 7, 8, and 9. Hence, the resistance per unit length can be set to be lower than the sources 7S, 8S, and 9S and drains 7D, 8D, and 9D. In addition, the current source line 18 and EL line 19 can be deposited thicker than the gates 7G, 8G, and 9G of the transistors 7, 8, and 9. Hence, the resistance per unit length can be set to be lower than the gates 7G, 8G, and 9G. For these reasons, the electrical resistances of the current source line 18 and EL line 19 can be set low. The time delay from the start of the light emission period until the organic EL element 26 emits light of desired brightness (gray level) can be suppressed. The voltage drop in the current source line 18 and EL line 19 can be suppressed. Furthermore, since the resistances of the current source line 18 and EL line 19 are low, any decrease in brightness, variation in brightness, and display degradation such as crosstalk in the electroluminescent display panel can be suppressed.

The present invention is not limited to the above embodiment, and various changes and modifications in design can be made without departing from the spirit and scope of the present invention.

For example, a contact hole may be provided in a gate insulating film 41 and planarizing film 11 to expose the scanning line 4 except the portion crossing the signal current line 3. An electroplating layer may be formed on the scanning line 4 in the same process as film formation of the current source line 18 and EL line 19. In this case, to insulate the plating layer from the common electrode 24, an insulating film is inserted, like the liquid-insulating films 33a and 33b. The plating layer is electrically connected to the gates of the transistors 7 and 8.

In the above embodiment, the transistors 7, 8, and 9 are n-channel thin-film transistors. The transistors 7, 8, and 9 may be p-channel thin-film transistors. When the transistors 7, 8, and 9 are p-channel thin-film transistors, connection of the source and drain reverses. In the description, "source" is changed to "drain", and "drain" is changed to "source". "High level" of a signal is changed to "low level", and "low level" is changed to "high level". Even in this case, the direction of the storage current does not change.

### [10th Embodiment]

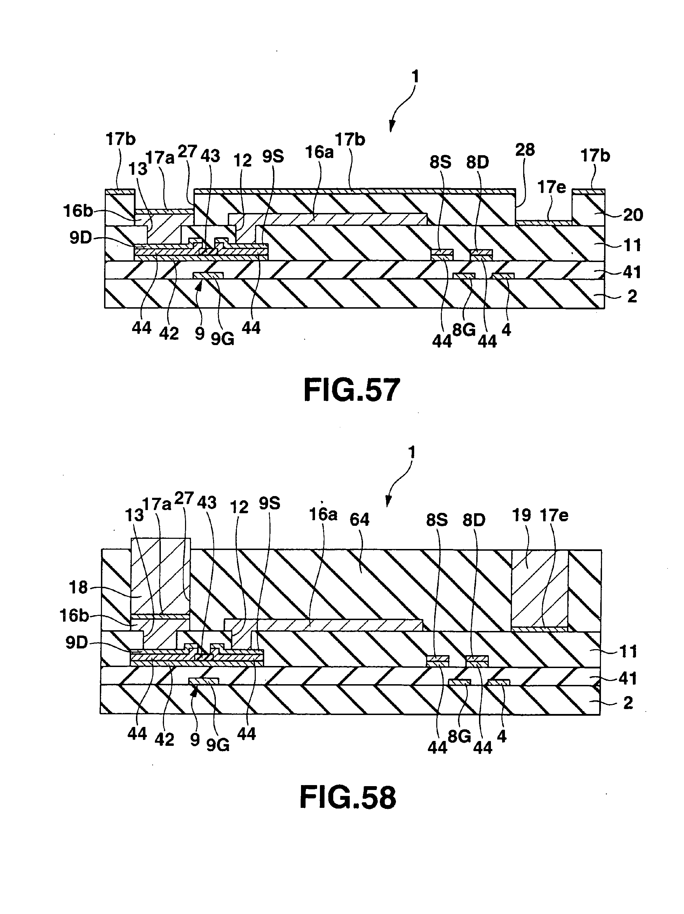

A method of manufacturing an electroluminescent display panel according to the 10th embodiment will be described with reference to FIGS. 57 to 61. FIGS. 57 to 61 are sectional views of steps in the manufacturing method. The steps are executed in the order of FIGS. 57 to 61. The same reference numerals as in the electroluminescent display panels of the first, eighth, and ninth embodiments denote the same parts in FIGS. 57 to 61.

As shown in FIG. 57, an interlayer dielectric film 20 is formed on a transistor array substrate 1 of the eighth embodiment shown in FIG. 44. A contact hole 27 is formed in the interlayer dielectric film 20 at a position corresponding to a drain 9D of a current control transistor 9 to expose the drain 9D. An opening portion 28 is formed in the interlayer dielectric film 20 at a position along the row direction on the side of one of the plurality of peripheral sides of a pixel electrode 16a, which opposes the peripheral side on side where a current source line 18 is to be formed. An underlayer much thinner than the interlayer dielectric film 20 is formed to form underlayers 17a and 17e which are cut by the step in the contact hole 27 and the step in the opening portion 28.

As shown in FIG. 58, a photoresist film 64 is formed while exposing the underlayers 17a and 17e. Electroplating is executed by using the underlayers 17a and 17a as electrodes. The current source line 18 formed from a thick copper plating film having a thickness of 2 to 100 µm, i.e., thicker than the sources, drains, and gates of transistors 7, 8, and 9, and a width of 5 to 50 µm is formed on the underlayer 17a. In addition, an EL line 19 formed from a thick copper plating film having a thickness of 2 to 100 µm and a width of 5 to 50 µm is formed on the underlayer 17e.

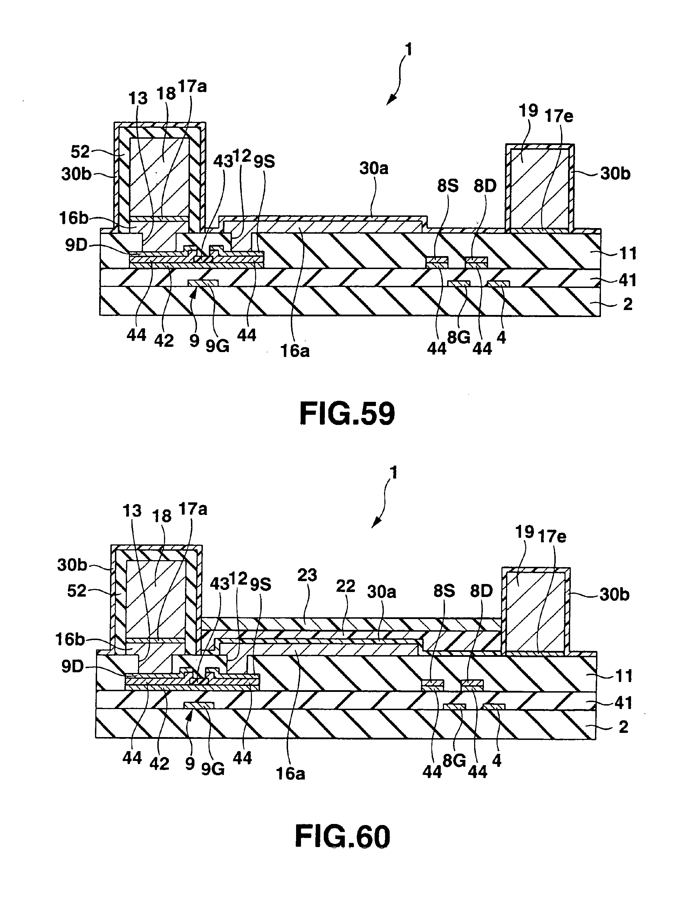

As shown in FIG. 59, the photoresist film 64 is removed. An insulating film 52 which covers at least the exposed surface of the current source line 18, the side surface of the underlayer 17a, and the side surface of an underlying interconnection 16b is formed. As in the ninth embodiment, a wettability changeable conductive film 30 is formed on the entire surface and irradiated with UV rays to pattern a lyophilic film 30a which is modified by the function of the photocatalyst. A portion which is not affected by the photocatalyst becomes a liquid-repellent film 30b.

As in the ninth embodiment, as shown in FIG. 60, a film of a solution or suspension containing the material of a hole transport layer 22 is selectively formed on the lyophilic film 30a by wet film deposition and dried to form the hole transport layer 22. After that, a light-emitting layer 23 is formed on the hole transport layer 22.

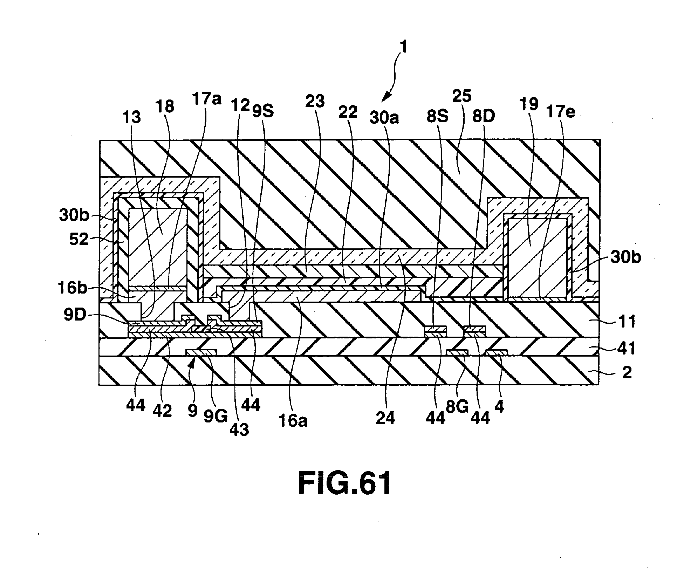

As shown in FIG. 61, a common electrode 24 made of a transparent electrode is formed on the entire surface. The upper surface is sealed by an overcoat insulating layer 25. The common electrode 24 is formed on the insulating film 52 and therefore electrically insulated from the current source line 18. Although the liquid-repellent film 30b is inserted between the common electrode 24 and the EL line 19, they are electrically connected because the liquid-repellent film 30b is very thin and has no sufficient insulating properties. Hence, all the EL lines 19 are connected to each other through the common electrode 24. The common electrode 24 is a transparent electrode made of ITO or the like and therefore has a high resistivity. However, since the EL line 19 is deposited thicker than sources 7S, 8S, and 9S, drains 7D, 8D, and 9D, and gates 7G, 8G, and 9G of the transistors 7, 8, and 9 such that the resistance per unit length becomes lower than these electrodes, a sufficient current can be supplied from the cathodes of organic EL elements 26 of all pixels. In addition, since the current source line 18 is deposited thicker than the sources 7S, 8S, and 9S, drains 7D, 8D, and 9D, and gates 7G, 8G, and 9G of the transistors 7, 8, and 9 such that the resistance per unit length becomes lower than these electrodes, a sufficient current can be supplied to the anodes of the organic EL elements 26 of the pixels of each row.

A current control driver is connected to a plurality of signal current lines 3 on a substrate 2. A scan driver is connected to a plurality of scanning lines 4. A driving driver is connected to the plurality of current source lines 18. The plurality of EL lines 19 are set to an equipotential such as the ground potential and maintained at a constant voltage.

The embodiments include various kinds of limitations which are preferable in terms of techniques for practicing the present invention. However, the scope of the present invention is not limited to the above-described embodiments and illustrated examples.

In the above embodiments, the drain 8D of the holding transistor 8 is connected to the current source line 18. Even when the drain 8D is connected to the scanning line 4 instead, the same operation as described above can be executed.

In the above embodiments, the source 9S of the current control transistor 9 is connected to the anode of the organic EL element 26. The EL line 19 is connected to the cathode of the organic EL element 26. However, the present invention is not limited to this. The source 9S of the current control transistor 9 may be connected to the cathode of the organic EL element 26. The EL line 19 may be connected to the anode of the organic EL element 26.

In the above embodiments, the current source line 18 partitions the hole transport layer 22 as at least one side of the block where the hole transport layer 22 is formed and also partitions the light-emitting layer 23 as at least one side of the block where the light-emitting layer 23 is formed. Even when the organic EL element 26 has a single light-emitting layer without any hole transport layer, the current source line 18 may partition the light-emitting layer as at least one side of the block where the light-emitting layer is formed. Even when the organic EL element 26 has an electron transport layer, the current source line 18 may partition the electron transport layer as at least one side of the block where the electron transport layer is formed.

Similarly, even when the organic EL element 26 has a single light-emitting layer without any hole transport layer, the EL line 19 may partition the light-emitting layer as at least one side of the block
where the light-emitting layer is formed. Even when the organic EL element 26 has an electron transport layer, the EL line 19 may partition the electron transport layer as at least one side of the block where the electron transport layer is formed.

## Claims

1. A display device **characterized by** comprising:
a substrate;
a light-emitting element which is provided on one side of the substrate;
a pixel circuit which is provided on said side of the substrate, and has at least one electrode to drive the light-emitting element; and
an interconnection which is provided on said side of substrate, is electrically connected to the pixel circuit and has a conductive layer different from the electrode of the pixel circuit.

2. A device according to claim 1, **characterized in that** a resistance per unit length of the conductive layer is lower than a resistance per unit length of the electrode of the pixel circuit.

3. A device according to claim 1, **characterized in that** the conductive layer is thicker than the electrode of the pixel circuit.

4. A device according to claim 1, **characterized in that** a resistivity of the conductive layer is lower than a resistivity of the electrode of the pixel circuit.

5. A device according to claim 1, **characterized in that** the pixel circuit has at least one thin-film transistor.

6. A device according to claim 5, **characterized in that** the pixel circuit includes a source electrode and a drain electrode.

7. A display device **characterized by** comprising:
a substrate;
a plurality of light-emitting elements;
a plurality of pixel circuits each of which has at least one electrode to drive a corresponding one of the light-emitting elements; and
a pixel circuit connecting interconnection which is electrically connected to said plurality of pixel circuits and has a conductive layer different from the electrode of the pixel circuit,
the light emitting elements, pixel circuits and pixel circuit interconnection being on one side of the substrate.

8. A device according to claim 7, **characterized in that** a resistance per unit length of the conductive layer of the pixel circuit connecting interconnection is lower than a resistance per unit length of the electrode of the pixel circuit.

9. A device according to claim 7, **characterized in that** the conductive layer of the pixel circuit connecting interconnection is thicker than the electrode of the pixel circuit.

10. A device according to claim 7, **characterized in that** a resistivity of the conductive layer of the pixel circuit connecting interconnection is lower than a resistivity of the electrode of the pixel circuit.

11. A device according to claim 7, **characterized in that** the pixel circuit has at least one thin-film transistor.

12. A device according to claim 11, **characterized in that** each of the pixel circuits has a source electrode and a drain electrode.

13. A device according to claim 7, **characterized by** further comprising a light-emitting element connecting interconnection which is connected to said plurality of light-emitting elements and has a conductive layer different from the electrode of the pixel circuit.

14. A device according to claim 7, **characterized in that** each of the pixel circuits comprises
a switch circuit which supplies a storage current having a current value to a signal current line during a selection period and stops supplying the current to the signal current line during a non-selection period, and
a current storage circuit which stores current data corresponding to the current value of the storage current flowing through the signal current line during the selection period and supplies, to the light-emitting element, a driving current having a current value corresponding to the current value of the storage current during the non-selection period in accordance with the current data stored during the selection period.

15. A device according to claim 14, **characterized in that** the current storage circuit has a current control transistor which supplies the driving current to the light-emitting element.

16. A device according to claim 14, **characterized in that** the switch circuit has a current path control transistor in which one of a source and a drain is connected to the signal current line and which supplies the storage current to the signal current line during the selection period and stops supplying the driving current to the signal current line during the non-selection period.

17. A device according to claim 14, **characterized in that** the switch circuit has a holding transistor which controls a write of the current data in the current storage circuit.

18. A device according to claim 7, which **characterized by** further comprises a light-emitting element connecting interconnection which is connected to said plurality of light-emitting elements and has a conductive layer different from the electrode of the pixel circuit, and
in which the light-emitting element has a light-emitting layer and a pixel electrode, the light-emitting layer being formed on the pixel electrode between the pixel circuit connecting interconnection and the light-emitting element connecting interconnection.

19. A display device **characterized by** comprising:
a substrate;
a plurality of light-emitting elements which are provided on or above the substrate;
a plurality of pixel circuits each of which has an electrode to drive a corresponding one of the light-emitting elements; and
a light-emitting element connecting interconnection which is connected to said plurality of light-emitting elements and has a conductive layer different from the electrode of the pixel circuit.

20. A device according to claim 19, **characterized in that** a resistance per unit length of the conductive layer of the light-emitting element connecting interconnection is lower than a resistance per unit length of the electrode of the pixel circuit.

21. A device according to claim 19, **characterized in that** the conductive layer of the light-emitting element connecting interconnection is thicker than the electrode of the pixel circuit.

22. A device according to claim 19, **characterized in that** a resistivity of the conductive layer of the light-emitting element connecting interconnection is lower than a resistivity of the electrode of the pixel circuit.

23. A device according to claim 19, **characterized by** further comprising a pixel circuit connecting interconnection which is connected to said plurality of pixel circuits and has a conductive layer different from the electrode of the pixel circuit.

24. A display device **characterized by** comprising:
a plurality of light-emitting elements each of which has a light-emitting layer;
a plurality of pixel circuits which drive said plurality of light-emitting elements, respectively; and
an interconnection which is connected to one of the pixel circuit and the light-emitting element and has a conductive layer which partitions the light-emitting layer as at least one side of a block where the light-emitting layer of the light-emitting element is formed.

25. A device according to claim 24, **characterized in that** a resistance per unit length of the conductive layer is lower than a resistance per unit length of the electrode of the pixel circuit.

26. A device according to claim 24, **characterized in that** the conductive layer is thicker than the electrode of the pixel circuit.

27. A device according to claim 24, **characterized in that** a resistivity of the conductive layer is lower than a resistivity of the electrode of the pixel circuit.

28. A device according to claim 24, **characterized in that** the pixel circuit has a thin-film transistor.

29. A device according to claim 28, **characterized in that** each of the pixel circuits includes a source and a drain.

30. A device according to claim 24, **characterized in that**
each of said plurality of light-emitting elements has a pixel electrode, and
a lyophilic film is formed on a surface of the pixel electrode.

31. A device according to claim 24, **characterized in that** the pixel circuit comprises
a switch circuit which supplies a storage current having a predetermined current value to a current line during a selection period and stops supplying the current to the current line during a non-selection period, and
a current storage circuit which stores current data corresponding to the current value of the storage current flowing through the current line during the selection period and supplies, to the light-emitting element, a driving current having a current value corresponding to the current value of the storage current during the non-selection period in accordance with the current data stored during the selection period.

32. A device according to claim 31, **characterized in that** the current storage circuit has a current control transistor which supplies the driving current to the light-emitting element.

33. A device according to claim 31, **characterized in that** the switch circuit has a current path control transistor in which one of a source and a drain is connected to the current line and which supplies the storage current to the current line during the selection period and stops supplying the driving current to the current line during the non-selection period.

34. A device according to claim 31, **characterized in that** the switch circuit has a holding transistor which controls a write of the current data in the current storage circuit.

35. A device according to claim 24, **characterized in that** the interconnection includes a first interconnection connected to the pixel circuit and a second interconnection connected to the light-emitting element.

36. A device according to claim 35, **characterized in that** the first interconnection is connected to the pixel circuit through a contact hole provided in an insulating film which covers the pixel circuit.

37. A device according to claim 35, **characterized in that** the second interconnection is arranged above an insulating film which covers the pixel circuit.

38. A device according to claim 35, **characterized in that** the second interconnection is connected to a transparent electrode.

39. A device according to claim 24, **characterized in that**
the light-emitting element has a pixel electrode, and
the interconnection is arranged at a position not to overlap the pixel electrode.

40. A method of manufacturing a display device, **characterized by** comprising:
forming a pixel circuit connecting interconnection which is connected to a plurality of pixel circuits provided on a substrate and has a conductive layer different from an electrode of the pixel circuit.

41. A method according to claim 40, **characterized in that** the pixel circuit connecting interconnection is formed by plating.

42. A method according to claim 41, **characterized in that**
the display device comprises a plurality of light-emitting elements each having a light-emitting layer, and
the light-emitting layer is formed between the pixel circuit connecting interconnection and a light-emitting element connecting interconnection to be connected to said plurality of light-emitting elements.

43. A method of manufacturing a display device, **characterized by** comprising:
providing an interconnection which has a conductive layer different from electrodes of a plurality of pixel circuits provided on a substrate; and
forming a light-emitting layer by using the interconnection as a partition.

44. A method according to claim 43, **characterized in that** the interconnection is formed by plating.

45. A method according to claim 43, **characterized in that** the light-emitting layer is formed by a wet process.
